# EUROPEAN PATENT APPLICATION

(11) **EP 1 995 281 A1**
(43) Date of publication of application: **26.11.2008**
(21) Application number: 07737417.1
(22) Date of filing: 27.02.2007
(51) Int. Cl.: C08L 83/04, C08G 77/44, H01L 23/29, H01L 23/31, H01L 33/00

(54) **OXIDE PARTICLE-CONTAINING POLYSILOXANE COMPOSITION AND METHOD FOR PRODUCING SAME**

(30) Priority: 16.03.2006 JP 2006073215; 16.03.2006 JP 2006073216; 16.03.2006 JP 2006073217; 31.03.2006 JP 2006100013; 12.06.2006 JP 2006162876; 12.06.2006 JP 2006162877; 12.06.2006 JP 2006162878; 31.10.2006 JP 2006295912
(71) Applicant: JSR Corporation, Tokyo 104-0045 (JP)
(72) Inventor: KANAMORI, Tarou, JSR CORPORATION, Tokyo 1040045 (JP); SHIMIZU, Tatsuya, JSR CORPORATION, Tokyo 1040045 (JP); YAJIMA, Keisuke, JSR CORPORATION, Tokyo 1040045 (JP); NISHIKAWA, Akira, JSR CORPORATION, Tokyo 1040045 (JP)
(74) Representative: TBK-Patent
(86) International application number: PCT/JP2007/053615
(87) International publication number: WO 2007/108281

(57) **Abstract**

The oxide fine particle-containing polysiloxane composition of the present invention is obtained by mixing (A) silicon oxide fine particles and/or metal oxide fine particles with (B) polyfunctional polysiloxane in an organic solvent in the presence of a basic compound, an acidic compound or a metal chelate compound and thereby dispersing the oxide fine particles (A) in the organic solvent. In the oxide fine particle-containing polysiloxane composition, the oxide fine particles are highly dispersed in the organic solvent without using phosphoric acid or the like having an organic group of 6 or more carbon atoms or a compound having an oxyalkylene group. A polysiloxane-based cured product obtained from such an oxide fine particle-containing polysiloxane composition has excellent transparency and is hardly yellowed even at high temperatures.

## Description

### TECHNICAL FIELD

The present invention relates to a polysiloxane composition wherein silicon oxide fine particles and/or metal oxide fine particles are highly dispersed in an organic solvent containing polyfunctional polysiloxane having a dimethylsiloxane chain or polyfunctional polysiloxane having a hydroxyl group or an alkoxy group, and a cured product of the composition.

### BACKGROUND ART

As a means to impart various functions to siloxane materials having excellent durability, combining of a binder having a siloxane skeleton (also referred to as a "siloxane-based binder" hereinafter) with silicon oxide and/or various metal oxides has been studied in the past. As one of the siloxane-based binders, polydimethylsiloxane is known. This polydimethylsiloxane is not deteriorated unless the ambient temperature is a high temperature of usually not lower than 200°C, and it is useful as a siloxane-based binder excellent in heat resistance and ultraviolet light resistance. Moreover, the polydimethylsiloxane is excellent also in flexibility, and therefore, it is used for various purposes.

When the siloxane-based binder and silicone oxide or metal oxide are combined, they are frequently prepared in the forms of dispersions. The siloxane-based binder, however, is sparingly soluble in water, and hence, it is necessary to use an organic solvent as a dispersion medium. On the other hand, silicon oxide fine particles and metal oxide fine particles (together referred to as "oxide fine particles" hereinafter) are liable to be aggregated in an organic solvent, and hence, they are frequently dispersed in an aqueous medium. On this account, in order to finely disperse the oxide fine particles in an organic solvent, it is necessary to use phosphoric acid, sulfonic acid or carboxylic acid having an organic group of 6 or more carbon atoms (see patent document 1), an organic compound having an oxyalkylene group or an ester of phosphoric acid or the like having an oxyalkylene group (see patent document 2), or a silane compound having an oxyalkylene group (see patent document 3).

In the case where the oxide fine particles and the siloxane-based binder are combined by the method of finely dispersing the oxide fine particles in an organic solvent using the above compounds, dispersibility in the dispersion is excellent, but compatibility of the above compounds with the siloxane-based binder is bad, and for example, when the solvent is removed to form a coating film, the coating film is sometimes whitened. Further, even if a transparent coating film is formed by controlling the film-forming conditions, etc., phosphoric acid or the like having an organic group of 6 or more carbon atoms or a compound having an oxyalkylene group remains in the coating film, and consequently, disadvantages, such as coloring and occurrence of a crack of the coating film, are sometimes brought about in severe environment such as environment under irradiation with ultraviolet light or at high temperatures of not lower than 150°C.

In the case where a transparent coating film is formed by the use of a conventional polysiloxane composition containing oxide fine particles, the polysiloxane composition contains a dispersion solvent of usually 30 to 90% by weight, and in order to secure dispersion stability of the oxide fine particles, the viscosity of the composition, as measured by an E type viscometer under the conditions of 25°C and a rotor rotational speed of 5 rpm, is adjusted to a low viscosity of usually not more than 15 mPa·s. If a filler having a high specific gravity is added to the oxide fine particle-containing polysiloxane composition of such a low viscosity, the filler sometimes undergoes sedimentation separation. On this account, an organic thickening agent such as polyethylene glycol has been added to increase viscosity in the past. However, because of heat or ultraviolet light, coloring or cracking occurs, and resistances, such as heat resistance and ultraviolet light resistance, are deteriorated. Although the viscosity can be increased by, for example, increasing a solids concentration without adding the organic thickening agent such as polyethylene glycol, the siloxane-based binder sometimes gels, or the oxide fine particles are sometimes sedimented.

On the other hand, the silicon oxide fine particles may be in the form of an organic solvent dispersion wherein dispersibility of the fine particles is maintained by surface charge of the fine particles themselves, and this dispersion has excellent dispersion stability. However, when the dispersion is mixed with the siloxane-based binder, the silicon oxide fine particles are sometimes aggregated and are whitened, or a crack sometimes occurs.
Patent document 1: Japanese Patent Laid-Open Publication No. 283822/2004
Patent document 2: Japanese Patent Laid-Open Publication No. 185924/2005
Patent document 3: Japanese Patent Laid-Open Publication No. 99879/2004

### DISCLOSURE OF THE INVENTION

### PROBLEM TO BE SOLVE BY THE INVENTION

The present invention is intended to solve such problems associated with the prior art as mentioned above, and it is an object of the present invention to provide a polysiloxane-based cured product which is excellent in transparency and is hardly yellowed even at high temperatures, a polysiloxane composition in which oxide fine particles are highly dispersed in an organic solvent and from which such a cured product as above can be obtained, and a process for preparing the polysiloxane composition, without using phosphoric acid or the like having an organic group of 6 or more carbon atoms or a compound having an oxyalkylene group.

### MEANS TO SOLVE THE PROBLEM

In order to solve the above problems, the present inventors have earnestly studied, and as a result, they have found that a polysiloxane composition wherein oxide fine particles are highly dispersed in an organic solvent is obtained by treating the oxide fine particles in the organic solvent in the presence of a basic compound, an acidic compound or a metal chelate compound. Further, the present inventors have found that a cured product obtained from the above composition is excellent in transparency and is hardly yellowed even at high temperatures, and they have achieved the present invention.

That is to say, the oxide fine particle-containing polysiloxane composition according to the present invention is obtained by mixing:
(A) silicon oxide fine particles and/or metal oxide fine particles with
(B1) polyfunctional polysiloxane which is obtained by allowing alkoxy-terminated polyfunctional polysiloxane (b1) represented by the following average compositional formula (1):

   R¹ₐSiO_{b}(OR²)_{c} (1)

   wherein R¹ is a hydrogen atom or a monovalent hydrocarbon group having no oxyalkylene group, when plural R¹ are present, they may be the same as or different from one another, R² is an alkyl group, when plural R² are present, they may be the same as or different from one another, a is more than 0 but less than 2, b is more than 0 but less than 2, c is more than 0 but less than 4, and a+b×2+c=4, and
   having a weight-average molecular weight, as measured by gel permeation chromatography, of not less than 500 but less than 3,000 in terms of polystyrene, and hydroxy-terminated polydimethylsiloxane (b2) having a weight-average molecular weight, as measured by gel permeation chromatography, of not less than 2,000 but not more than 100,000 in terms of polystyrene to undergo dealcoholization reaction in a weight ratio (b1/b2) of 3/97 to 55/45 based on 100 parts by weight of the total thereof, or
(B2) polyfunctional polysiloxane which is obtained by allowing hydroxy-terminated polyfunctional polysiloxane (b3) represented by the following average compositional formula (2) :

   R¹ₐSiO_{b}(OH)_{c} (2)

   wherein R¹ is a hydrogen atom or a monovalent hydrocarbon group having no oxyalkylene group, when plural R¹ are present, they may be the same as or different from one another, a is more than 0 but less than 2, b is more than 0 but less than 2, c is more than 0 but less than 4, and a+b×2+c=4, and having a weight-average molecular weight, as measured by gel permeation chromatography, of not less than 500 but less than 3,000 in terms of polystyrene, and alkoxy-terminated polydimethylsiloxane (b4) having a weight-average molecular weight, as measured by gel permeation chromatography, of not less than 2,000 but not more than 100,000 in terms of polystyrene to undergo dealcoholization reaction in a weight ratio (b3/b4) of 3/97 to 55/45 based on 100 parts by weight of the total thereof, or
(B3) polyfunctional polysiloxane which is represented by the following average compositional formula (3):

   R¹ₐSiO_{b}(OR³)_{c} (3)

   wherein R¹ is a hydrogen atom or a monovalent hydrocarbon group having no oxyalkylene group, when plural R¹ are present, they may be the same as or different from one another, R³ is a hydrogen atom or an alkyl group, when plural R³ are present, they may be the same as or different from one another, a is more than 0 but less than 2, b is more than 0 but less than 2, c is more than 0 but less than 4, and a+b×2+c=4,
   in an organic solvent in the presence of a basic compound, an acidic compound or a metal chelate compound and thereby dispersing the oxide fine particles (A) in the organic solvent.

It is preferable that the oxide fine particles (A) and the polyfunctional polysiloxane (B1), (B2) or (B3) are mixed in the presence of the basic compound, and it is more preferable that the basic compound is an organic amine compound.
The oxide fine particles (A) and the polyfunctional polysiloxane (B1), (B2) or (B3) are preferably mixed by a bead mill.

The polyfunctional polysiloxane (B1), (B2) or (B3) is preferably mixed in an amount of 1 to 1000 parts by weight in terms of a perfect hydrolysis condensate, based on 100 parts by weight of the oxide fine particles (A).
The oxide fine particle-containing polysiloxane composition preferably has a water content of not more than 5% by weight.

In the oxide fine particle-containing polysiloxane composition obtained by mixing the oxide fine particles (A) with the polyfunctional polysiloxane (B1) or (B2), the polyfunctional polysiloxane (B1) or (B2) is preferably further subjected to hydrolysis/condensation and then mixed with the oxide fine particles (A), and a catalyst in the dealcoholization reaction is preferably a metal chelate compound.

In the oxide fine particle-containing polysiloxane composition obtained by mixing the oxide fine particles (A) with the polyfunctional polysiloxane (B3), the weight-average molecular weight of the polyfunctional polysiloxane (B3), as measured by gel permeation chromatography, is preferably in the range of 1,000 to 100,000 in terms of polystyrene.

The cured product according to the present invention is obtained from the above-mentioned oxide fine particle-containing polysiloxane composition.
The LED sealing material according to the present invention is obtained by further mixing the above-mentioned oxide fine particle-containing polysiloxane composition with a fluorescent substance.

The process for preparing an oxide fine particle-containing polysiloxane composition according to the present invention comprises preparing:
(B1) polyfunctional polysiloxane which is obtained by allowing alkoxy-terminated polyfunctional polysiloxane (b1) represented by the following average compositional formula (1):

   R¹ₐSiO_{b}(OR²)_{c} (1)

   wherein R¹ is a hydrogen atom or a monovalent hydrocarbon group having no oxyalkylene group, when plural R¹ are present, they may be the same as or different from one another, R² is an alkyl group, when plural R² are present, they may be the same as or different from one another, a is more than 0 but less than 2, b is more than 0 but less than 2, c is more than 0 but less than 4, and a+b×2+c=4, and having a weight-average molecular weight, as measured by gel permeation chromatography, of not less than 500 but less than 3,000 in terms of polystyrene, and hydroxy-terminated polydimethylsiloxane (b2) having a weight-average molecular weight, as measured by gel permeation chromatography, of not less than 2,000 but not more than 100,000 in terms of polystyrene to undergo dealcoholization reaction in a weight ratio (b1/b2) of 3/97 to 55/45 based on 100 parts by weight of the total thereof, or
(B2) polyfunctional polysiloxane which is obtained by allowing hydroxy-terminated polyfunctional polysiloxane (b3) represented by the following average compositional formula (2) :

   R¹ₐSiO_{b}(OH)_{c} (2)

   wherein R¹ is a hydrogen atom or a monovalent hydrocarbon group having no oxyalkylene group, when plural R¹ are present, they may be the same as or different from one another, a is more than 0 but less than 2, b is more than 0 but less than 2, c is more than 0 but less than 4, and a+b×2+c=4, and having a weight-average molecular weight, as measured by gel permeation chromatography, of not less than 500 but less than 3,000 in terms of polystyrene, and alkoxy-terminated polydimethylsiloxane (b4) having a weight-average molecular weight, as measured by gel permeation chromatography, of not less than 2,000 but not more than 100,000 in terms of polystyrene to undergo dealcoholization reaction in a weight ratio (b3/b4) of 3/97 to 55/45 based on 100 parts by weight of the total thereof, or
(B3) polyfunctional polysiloxane which is represented by the following average compositional formula (3):

   R¹ₐSiO_{b}(OR³)_{c} (3)

   wherein R¹ is a hydrogen atom or a monovalent hydrocarbon group having no oxyalkylene group, when plural R¹ are present, they may be the same as or different from one another, R³ is a hydrogen atom or an alkyl group, when plural R³ are present, they may be the same as or different from one another, a is more than 0 but less than 2, b is more than 0 but less than 2, c is more than 0 but less than 4, and a+b×2+c=4, and then mixing the polyfunctional polysiloxane (B1), (B2) or (B3) with silicon oxide fine particles and/or metal oxide fine particles (A) in an organic solvent in the presence of a basic compound, an acidic compound or a metal chelate compound.

The oxide fine particles (A) and the polyfunctional polysiloxane (B1), (B2) or (B3) are preferably mixed in the presence of the basic compound, and the basic compound is preferably an organic amine compound. The oxide fine particles (A) and the polyfunctional polysiloxane (B1), (B2) or (B3) are preferably mixed by a bead mill.

In the process for preparing an oxide fine particle-containing polysiloxane composition comprising mixing the oxide fine particles (A) with the polyfunctional polysiloxane (B1) or (B2), the polyfunctional polysiloxane (B1) or (B2) is preferably further subjected to hydrolysis/condensation and then mixed with the oxide fine particles (A), and a catalyst in the dealcoholization reaction is preferably a metal chelate compound.

### EFFECT OF THE INVENTION

According to the present invention, a composition wherein oxide fine particles are highly dispersed in an organic solvent containing polysiloxane having a dimethylsiloxane chain is obtained without using phosphoric acid or the like having an organic group of 6 or more carbon atoms or a compound having an oxyalkylene group. This composition not only has excellent stability but also can form a cured product containing oxide fine particles and the polysiloxane. The cured product does not substantially contain the above compound, and therefore, even if the cured product is exposed to sever environment, it is not deteriorated and has excellent transparency. Moreover, the cured product is hardly yellowed even at high temperatures. When the polysiloxane has a dimethylsiloxane chain of an appropriate length, it is excellent in flexibility, and hence, a cured product having a large thickness can be also formed. In particular, a cured product using metal oxide fine particles of high refractive index as the oxide fine particles can be used as a sealing material of an LED element using a blue LED element or an ultraviolet LED element as a light emitting element.

### BEST MODE FOR CARRYING OUT THE INVENTION

The oxide fine particle-containing polysiloxane composition of the invention can be obtained by mixing oxide fine particles (A) with polyfunctional polysiloxane (B) in an organic solvent in the presence of a basic compound, an acidic compound or a metal chelate compound and thereby performing dispersing treatment, without using phosphoric acid or the like having an organic group of 6 or more carbon atoms or a compound having an oxyalkylene group.

### Oxide fine particles (A)

The oxide fine particles (A) for use in the invention are silicon oxide fine particles and/or metal oxide fine particles. The metal oxide fine particles are not specifically restricted in their types provided that they are fine particles of an oxide of a metal element, and examples thereof include fine particles of metal oxides, such as antimony oxide, zirconium oxide, anatase titanium oxide, rutile titanium oxide, brookite titanium oxide, zinc oxide, tantalum oxide, indium oxide, hafnium oxide, tin oxide, niobium oxide, aluminum oxide, cerium oxide, scandium oxide, yttrium oxide, lanthanum oxide, praseodymium oxide, neodymium oxide, samarium oxide, europium oxide, gadolinium oxide, terbium oxide, dysprosium oxide, holmium oxide, erbium oxide, thulium oxide, ytterbium oxide, lutetium oxide, calcium oxide, gallium oxide, lithium oxide, strontium oxide, tungsten oxide, barium oxide and magnesium oxide, composites of these oxides, and oxides of composites of two or more kinds of the above metals, such as indium-tin composite oxide. Further, fine particles of a composite oxide of silicon oxide and a metal oxide, or oxide fine particles obtained by coating surfaces of metal oxide fine particles with silicon oxide are also employable as the oxide fine particles.

In the present invention, the oxide fine particles may be used singly or as a mixture of two or more kinds. The oxide fine particles (A) can be properly selected according to the function to be imparted, and for example, in order to impart high refraction property, TiO₂ fine particles are preferable, in order to reconcile transparency in the ultraviolet region with high refraction property, ZrO₂ fine particles are preferable, and in order to impart UV cut-off function, cerium oxide fine particles or zinc oxide fine particles are preferable.

The average primary particle diameter of the oxide fine particles (A) is in the range of preferably 0.1 to 100 nm, more preferably 0.1 to 70 nm, particularly preferably 0.1 to 50 nm. When the average primary particle diameter of the oxide fine particles (A) is in the above range, a cured product having excellent light transmittance can be obtained.

Such oxide fine particles (A) may be added in the form of a powder that is not dissolved in a solvent, or may be added in the form of a dispersion wherein the particles are dispersed in a polar solvent such as isopropyl alcohol or a non-polar solvent such as toluene. The oxide fine particles (A) before adding may be agglomerated to form secondary particles. In the present invention, it is preferable to use a powder from the viewpoint that an appropriate organic solvent can be properly selected taking solubility of the polyfunctional polysiloxane (B) into account. The preparation process of the invention is particularly effective for the case of adding the oxide fine particles in the form of a powder.

### Polyfunctional polysiloxane (B)

In the present invention, polyfunctional polysiloxane having a dimethylsiloxane chain or polyfunctional polysiloxane having a hydroxyl group and/or an alkoxy group is employable as the polyfunctional polysiloxane (B).

### Polyfunctional polysiloxane having dimethylsiloxane chain

As the polyfunctional polysiloxane having a dimethylsiloxane chain, there can be mentioned polysiloxane (B1) which is obtained by allowing alkoxy-terminated polyfunctional polysiloxane (b1) having a weight-average molecular weight, as measured by gel permeation chromatography, of not less than 500 but less than 3,000 in terms of polystyrene and hydroxy-terminated polydimethylsiloxane (b2) having a weight-average molecular weight, as measured by gel permeation chromatography, of not less than 2,000 but not more than 100,000 in terms of polystyrene to undergo dealcoholization reaction, or polysiloxane (B2) which is obtained by allowing hydroxy-terminated polyfunctional polysiloxane (b3) having a weight-average molecular weight, as measured by gel permeation chromatography, of not less than 500 but less than 3,000 in terms of polystyrene and alkoxy-terminated polydimethylsiloxane (b4) having a weight-average molecular weight, as measured by gel permeation chromatography, of not less than 2,000 but not more than 100,000 in terms of polystyrene to undergo dealcoholization reaction.

### (b1) Alkoxy-terminated polyfunctional polysiloxane

The alkoxy-terminated polyfunctional polysiloxane (b1) for use in the invention is polyfunctinal polysiloxane having an alkoxy group and represented by the following average compositional formula (1):

R¹ₐSiO_{b}(OR²)_{c} (1),

and it preferably has a three-dimensional crosslinked structure.

In the formula (1), R¹ is a hydrogen atom or a monovalent hydrocarbon group having no oxyalkylene group, when plural R¹ are present, they may be the same as or different from one another, R² is an alkyl group, when plural R² are present, they may be the same as or different from one another, a is more than 0 but less than 2, b is more than 0 but less than 2, c is more than 0 but less than 4, and a+b×2+c=4. When plural R¹ and plural R² are present, a indicates a ratio of the total of hydrogen atoms and monovalent hydrocarbon groups having no oxyalkylene group to silicon atoms, and c indicates a ratio of alkoxy groups to silicon atoms.

The weight-average molecular weight of the alkoxy-terminated polysiloxane (b1), as measured by gel permeation chromatography, is not less than 500 but less than 3,000, more preferably not less than 550 but less than 3,000, particularly preferably not less than 600 but less than 3,000, in terms of polystyrene. When the alkoxy-terminated polysiloxane (b1) having a weight-average molecular weight of the above range is used, inhibition of occurrence of a crack and excellent curability can be reconciled in the formation of a cured product.

Although the monovalent hydrocarbon group is not specifically restricted provided that it has no oxyalkylene group, a substituted or unsubstituted monovalent hydrocarbon group can be mentioned as the monovalent hydrocarbon group. The monovalent unsubstituted hydrocarbon group is, for example, an alkyl group of 1 to 8 carbon atoms, a phenyl group, a benzyl group or a tolyl group. Examples of the alkyl groups of 1 to 8 carbon atoms include methyl, ethyl, propyl, isopropyl, butyl, pentyl, hexyl, heptyl and octyl. The monovalent substituted hydrocarbon group is, for example, a substituted alkyl group of 1 to 8 carbon atoms. Examples of substituents of the substituted alkyl groups include halogen, an amino group, a mercapto group, an isocyanate group, a glycidyl group, a glycidoxy group and a ureido group.

Examples of the alkyl groups indicated by R² include methyl, ethyl, propyl, isopropyl and butyl. Of these alkyl groups, methyl and ethyl are preferable.

The alkoxy-terminated polyfunctional polysiloxane (b1) can be prepared by, for example, properly combining polyfunctional alkoxysilanes or polyfunctional chlorosilanes so as to satisfy the aforesaid average compositional formula and subjecting them to hydrolysis/condensation. However, hydrolysis/condensation of tetraalkoxysilanes only and hydrolysis/condensation of dialkoxysilanes only are excluded.

Examples of the polyfunctional alkoxysilanes include:
tetraalkoxysilanes, such as tetramethoxysilane, tetraethoxysilane, tetra-n-propoxysilane, tetra-i-propoxysilane and tetra-n-butoxysilane;
trialkoxysilanes, such as methyltrimethoxysilane, methyltriethoxysilane, ethyltrimethoxysilane, ethyltriethoxysilane, n-propyltrimethoxysilane, n-propyltriethoxysilane, i-propyltrimethoxysilane, i-propyltriethoxysilane, n-butyltrimethoxysilane, n-butyltriethoxysilane, n-pentyltrimethoxysilane, n-hexyltrimethoxysilane, n-heptyltrimethoxysilane, n-octyltrimethoxysilane, cyclohexyltrimethoxysilane, cyclohexyltriethoxysilane, phenyltrimethoxysilane, phenyltriethoxysilane, 3-chloropropyltrimethoxysilane, 3-chloropropyltriethoxysilane, 3,3,3-trifluoropropyltrimethoxysilane, 3,3,3-trifluoropropyltriethoxysilane, 3-aminopropyltrimethoxysilane, 3-aminopropyltriethoxysilane, 3-mercaptopropyltrimethoxysilane, 3-mercaptopropyltriethoxysilane, 3-isocyanatopropyltrimethoxysilane, 3-isocyanatopropyltriethoxysilane, 3-glycidoxypropyltrimethoxysilane, 3-glycidoxypropyltriethoxysilane, 2-(3,4-epoxycyclohexyl)ethyltrimethoxysilane, 2-(3,4-epoxycyclohexyl)ethyltriethoxysilane, 3-ureidopropyltrimethoxysilane and 3-ureidopropyltriethoxysilane; and
dialkoxysilanes, such as dimethyldimethoxysilane, dimethyldiethoxysilane, diethyldimethoxysilane, diethyldiethoxysilane, di-n-propyldimethoxysilane, di-n-propyldiethoxysilane, di-i-propyldimethoxysilane, di-i-propyldiethoxysilane, di-n-butyldimethoxysilane, di-n-butyldiethoxysilane, di-n-pentyldimethoxysilane, di-n-pentyldiethoxysilane, di-n-hexyldimethoxysilane, di-n-hexyldiethoxysilane, di-n-heptyldimethoxysilane, di-n-heptyldiethoxysilane, di-n-octyldimethoxysilane, di-n-octyldiethoxysilane, di-n-cyclohexyldimethoxysilane, di-n-cyclohexyldiethoxysilane, diphenyldimethoxysilane and diphenyldiethoxysilane. These alkoxysilanes can be used singly or as a mixture of two or more kinds.

In combination with the polyfunctional alkoxysilanes, monofunctional alkoxysilanes can be used. Examples of the monofunctional alkoxysilanes include trimethylmethoxysilane, trimethylethoxysilane, triethylmethoxysilane and triethylethoxysilane. These monofunctional alkoxysilanes are desirably used in amounts of not more than 10% by weight, preferably not more than 7% by weight, more preferably not more than 5% by weight, based on the total amount of the alkoxysilanes used.

As the alkoxy-terminated polyfunctional polysiloxanes (b1) satisfying the above molecular weight, commercially available siloxane polymers, such as X40-9290 (trade name) available from Shin-Etsu Silicone Co., Ltd. and XC96-B0446 (trade name) available from GE Toshiba Silicone Co., Ltd., are also employable.

The alkoxy-terminated polyfunctional polysiloxane (b1) may have a Si-OH bond within limits not detrimental to the effect of the present invention.

### (b2) Hydroxy-terminated polydimethylsiloxane

The weight-average molecular weight of the hydroxy-terminated polydimethylsiloxane (b2) for use in the invention, as measured by gel permeation chromatography, is not less than 2,000 but not more than 100,000, more preferably not less than 2,000 but not more than 80,000, particularly preferably not less than 3,000 but not more than 70,000, in terms of polystyrene. When the hydroxy-terminated polydimethylsiloxane (b2) having a weight-average molecular weight of the above range is used, polyfunctional polysiloxane (B1) having excellent flexibility can be obtained, and inhibition of occurrence of a crack and curability can be reconciled in the formation of a cured product. Therefore, film thickening of the cured product can be promoted.

The hydroxy-terminated polydimethylsiloxane (b2) can be prepared by, for example, subjecting dimethyldialkoxysilane or dimethyldichlorosilane to hydrolysis/condensation.

Examples of the dimethyldialkoxysilanes include dimethyldimethoxysilane, dimethyldiethoxysilane, dimethyldi-i-propoxysilane and dimethyldi-n-butoxysilane. These dimethyldialkoxysilanes can be used singly or as a mixture of two or more kinds.

The hydroxy-terminated polydimethylsiloxane (b2) can be prepared also by ring-opening condensation of cyclic organosiloxane. Examples of the cyclic organosiloxanes include hexaphenylcyclotrisiloxane, octaphenylcyclotetrasiloxane, tetravinyltetramethylcyclotetrasiloxane, hexamethylcyclotrisiloxane, octamethylcyclotetrasiloxane, pentamethylcyclotetrasiloxane, hexamethylcyclotetrasiloxane, tetramethylcyclotetrasiloxane, decamethylcyclopentasiloxane and dodecamethylcyclohexasiloxane.

As the hydroxy-terminated polydimethylsiloxanes (b2) satisfying the above molecular weight, commercially available hydroxy-terminated polydimethylsiloxanes, such as YF-3057, YF-3800, YF3802, YF-3897 and XF-3905 (trade names) available from GE Toshiba Silicone Co., Ltd., are also employable.

### (b3) Hydroxy-terminated polyfunctional polysiloxane

The hydroxy-terminated polyfunctional polysiloxane (b3) for use in the invention is polyfunctinal polysiloxane having a hydroxyl group and represented by the following average compositional formula (2):

R¹ₐSiO_{b}(OH)_{c} (2),

and it preferably has a three-dimensional crosslinked structure.

In the formula (2), R¹ is defined similarly to R¹ in the aforesaid formula (1). a is more than 0 but less than 2, b is more than 0 but less than 2, c is more than 0 but less than 4, and a+b×2+c=4. When plural R¹ and plural R² are present, a indicates a ratio of the total of hydrogen atoms and monovalent hydrocarbon groups having no oxyalkylene group to silicon atoms.

The weight-average molecular weight of the hydroxy-terminated polysiloxane (b3), as measured by gel permeation chromatography, is not less than 500 but less than 3,000, more preferably not less than 550 but less than 3,000, particularly preferably not less than 600 but less than 3,000, in terms of polystyrene. When the hydroxy-terminated polysiloxane (b3) having a weight-average molecular weight of the above range is used, inhibition of occurrence of a crack and excellent curability can be reconciled in the formation of a cured product.

Although the monovalent hydrocarbon group is not specifically restricted provided that it has no oxyalkylene group, a substituted or unsubstituted monovalent hydrocarbon group can be mentioned as the monovalent hydrocarbon group. Examples of the substituted or unsubstituted monovalent hydrocarbon groups include the same subsitututed or unsubstituted monovalent hydrocarbon groups as previously described for the alkoxy-terminated polyfunctional polysiloxane (b1).

The hydroxy-terminated polyfunctional polysiloxane (b3) can be prepared by, for example, properly combining polyfunctional alkoxysilanes or polyfunctional chlorosilanes so as to satisfy the aforesaid average compositional formula and subjecting them to hydrolysis/condensation. However, hydrolysis/condensation of tetraalkoxysilanes only and hydrolysis/condensation of dialkoxysilanes only are excluded.

Examples of the polyfunctional alkoxysilanes include the same polyfunctional alkoxysilanes as previously described for the alkoxy-terminated polyfunctional polysiloxane (b1), and they can be used singly or as a mixture of two or more kinds.

Also for the hydroxy-terminated polyfunctional polysiloxane (b3), the same monofunctional alkoxysilanes as previously described for the alkoxy-terminated polyfunctional polysiloxane (b1) can be used in combination with the polyfunctional alkoxysilanes. In this case, the monofunctional alkoxysilanes are desirably used in amounts of not more than 10% by weight, preferably not more than 7% by weight, more preferably not more than 5% by weight, based on the total amount of the alkoxysilanes used.

### (b4) Alkoxy-terminated polydimethylsiloxane

The weight-average molecular weight of the alkoxy-terminated polydimethylsiloxane (b4) for use in the invention, as measured by gel permeation chromatography, is not less than 2,000 but not more than 100,000, more preferably not less than 2,000 but not more than 80,000, particularly preferably not less than 3,000 but not more than 70,000, in terms of polystyrene. When the alkoxy-terminated polydimethylsiloxane (b4) having a weight-average molecular weight of the above range is used, polyfunctional polysiloxane (B2) having excellent flexibility can be obtained, and inhibition of occurrence of a crack and curability can be reconciled in the formation of a cured product. Therefore, film thickening of the cured product can be promoted.

The alkoxy-terminated polydimethylsiloxane (b4) can be prepared by, for example, subjecting dimethyldialkoxysilane or dimethyldichlorosilane to hydrolysis/condensation.

Examples of the dialkoxysilanes include the same dialkoxysilanes as previously described for the hydroxy-terminated polydimethylsiloxane (b2), and they can be used singly or as a mixture of two or more kinds.

### Process for preparing polyfunctional polysiloxane (B1) or (B2)

The polyfunctional polysiloxane (B1) can be prepared by allowing the alkoxy-terminated polyfunctional polysiloxane (b1) and the hydroxy-terminated polydimethylsiloxane (b2) to undergo dealcoholization reaction. Further, the polyfunctional polysiloxane (B2) can be prepared by allowing the hydroxy-terminated polyfunctional polysiloxane (b3) and the alkoxy-terminated polydimethylsiloxane (b4) to undergo dealcoholization reaction. These polyfunctional polysiloxanes (B1) and (B2) are preferably further subjected to hydrolysis/condensation after water is usually added to them. By virtue of this, the molecular weight of the polyfunctional polysiloxanes (B1) and (B2) is increased, and transparency of the resulting cured product is enhanced. Each of the above reactions is usually carried out in an organic solvent using a catalyst.

The mixing ratio by weight (b1/b2) of the alkoxy-terminated polyfunctional polysiloxane (b1) to the hydroxy-terminated polydimethylsiloxane (b2) is in the range of 3/97 to 55/45, preferably 5/95 to 50/50, more preferably 7/93 to 30/70, based on 100 parts by weight of the total thereof. The mixing ratio by weight (b3/b4) of the hydroxy-terminated polyfunctional polysiloxane (b3) to the alkoxy-terminated polydimethylsiloxane (b4) is in the range of 3/97 to 55/45, preferably 5/95 to 50/50, more preferably 7/93 to 30/70, based on 100 parts by weight of the total thereof. When the mixing ratio of the polysiloxane (b1) to the polysiloxane (b2) and the mixing ratio of the polysiloxane (b3) to the polysiloxane (b4) are in the above ranges, occurrence of a crack can be inhibited in the production of a cured product.

### Dealcoholization reaction

The temperature of the dealcoholization reaction is in the range of preferably 30 to 150°C, more preferably 40 to 120°C, particularly preferably 50 to 100°C. The reaction time is in the range of preferably 0.1 to 24 hours, more preferably 0.5 to 12 hours, particularly preferably 1 to 8 hours. The dealcoholization reaction may be carried out by introducing the components together into a reaction container, or may be carried out by adding one component to the other component intermittently or continuously.

Through the above dealcoholization reaction, polyfunctional polysiloxane (B1) having a structure wherein the alkoxy-terminated polysiloxane (b1) is bonded to each end of the hydroxy-terminated polydimethylsiloxane (b2) is formed, or polyfunctional polysiloxane (B2) having a structure wherein the hydroxy-terminated polysiloxane (b3) is bonded to each end of the alkoxy-terminated polydimethylsiloxane (b4) is formed.

### Hydrolysis/condensation reaction

The amount of water added in the hydrolysis/condensation reaction is in the range of usually 0.1 to 100 parts by weight, preferably 0.5 to 80 parts by weight, more preferably 1 to 50 parts by weight, based on 100 parts by weight of the polyfunctional polysiloxane (B1) or (B2). When the amount of water added is in the above range, the hydrolysis/condensation reaction sufficiently proceeds, so that such an amount is preferable.

The temperature of the hydrolysis/condensation reaction is in the range of preferably 20 to 150°C, more preferably 30 to 100°C, particularly preferably 40 to 80°C. The reaction time is in the range of preferably 0.1 to 24 hours, more preferably 0.5 to 12 hours, particularly preferably 1 to 8 hours.

### Organic solvent

Examples of the organic solvents employable in the dealcoholization reaction and the hydrolysis/condensation reaction include alcohols, aromatic hydrocarbons, ethers, ketones and esters. Examples of the alcohols include methanol, ethanol, n-propyl alcohol, i-propyl alcohol, i-butyl alcohol, n-butyl alcohol, sec-butyl alcohol, t-butyl alcohol, n-hexyl alcohol, n-octyl alcohol, ethylene glycol, diethylene glycol, triethylene glycol, ethylene glycol monobutyl ether, ethylene glycol monoethyl ether acetate, diethylene glycol monoethyl ether, propylene glycol monomethyl ether, propylene monomethyl ether acetate and diacetone alcohol. Examples of the aromatic hydrocarbons include benzene, toluene and xylene. Examples of the ethers include tetrahydrofuran and dioxane. Examples of the ketones include acetone, methyl ethyl ketone, methyl isobutyl ketone, diisobutyl ketone and cyclohexanone. Examples of the esters include ethyl acetate, propyl acetate, butyl acetate, propylene carbonate, methyl lactate, ethyl lactate, normal propyl lactate, isopropyl lactate, methyl 3-ethoxypropionate and ethyl 3-ethoxypropionate. These organic solvents may be used singly or may be used as a mixture of two or more kinds. Of these organic solvents, organic solvents other than alcohols, such as methyl ethyl ketone, methyl isobutyl ketone, toluene and xylene, are preferably used in the dealcoholization reaction from the viewpoint of acceleration of reaction. These organic solvents are preferably subjected to dehydration treatment to remove water content prior to use.

The organic solvent can be properly used for the purpose of controlling dealcoholization reaction and hydrolysis/condensation reaction, adjusting concentration or viscosity of a solution containing the resulting polyfunctinal polysiloxane (B1) or (B2), adjusting thickness of a cured product in the production of the cured product, or the like. When the organic solvent is used, the amount of the organic solvent can be properly determined according to the desired conditions, and for example, the organic solvent is used in such an amount that the concentration of the resulting polyfunctional polysiloxane (B1) or (B2) becomes preferably 5 to 99% by weight, more preferably 7 to 95% by weight, particularly preferably 10 to 90% by weight, in terms of a perfect hydrolysis condensate.

### Catalyst

The catalyst employable for the dealcoholization reaction or the hydrolysis/condensation reaction is, for example, a basic compound, an acidic compound or a metal chelate compound.

### Basic compound

Examples of the basic compounds include ammonia (including ammonia aqueous solution), organic amine compounds, hydroxides of alkali metals or alkaline earth metals, such as sodium hydroxide and potassium hydroxide, and alkoxides of alkali metals, such as sodium methoxide and sodium ethoxide. Of these, ammonia and the organic amine compounds are preferable.

Examples of the organic amines include alkylamine, alkoxyamine, alkanolamine and arylamine.
Examples of the alkylamines include alkylamines having an alkyl group of 1 to 4 carbon atoms, such as methylamine, ethylamine, propylamine, butylamine, hexylamine, octylamine, N,N-dimethylamine, N,N-diethylamine, N,N-dipropylamine, N,N-dibutylamine, trimethylamine, triethylamine, tripropylamine and tributylamine.

Examples of the alkoxyamines include alkoxyamines having an alkoxy group of 1 to 4 carbon atoms, such as methoxymethylamine, methoxyethylamine, methoxypropylamine, methoxybutylamine, ethoxymethylamine, ethoxyethylamine, ethoxypropylamine, ethoxybutylamine, propoxymethylamine, propoxyethylamine, propoxypropylamine, propoxybutylamine, butoxymethylamine, butoxyethylamine, butoxypropylamine and butoxybutylamine.

Examples of the alkanolamines include alkanolamines having an alkyl group of 1 to 4 carbon atoms, such as methanolamine, ethanolamine, propanolamine, butanolamine, N-methylmethanolamine, N-ethylmethanolamine, N-propylmethanolamine, N-butylmethanolamine, N-methylethanolamine, N-ethylethanolamine, N-propylethanolamine, N-butylethanolamine, N-methylpropanolamine, N-ethylpropanolamine, N-propylpropanolamine, N-butylpropanolamine, N-methylbutanolamine, N-ethylbutanolamine, N-propylbutanolamine, N-butylbutanolamine, N,N-dimethylmethanolamine, N,N-diethylmethanolamine, N,N-dipropylmethanolamine, N,N-dibutylmethanolamine, N,N-dimethylethanolamine, N,N-diethylethanolamine, N,N-dipropylethanolamine, N,N-dibutylethanolamine, N,N-dimethylpropanolamine, N,N-diethylpropanolamine, N,N-dipropylpropanolamine, N,N-dibutylpropanolamine, N,N-dimethylbutanolamine, N,N-diethylbutanolamine, N,N-dipropylbutanolamine, N,N-dibutylbutanolamine, N-methyldimethanolamine, N-ethyldimethanolamine, N-propyldimethanolamine, N-butyldimethanolamine, N-methyldiethanolamine, N-ethyldiethanolamine, N-propyldiethanolamine, N-butyldiethanolamine, N-methyldipropanolamine, N-ethyldipropanolamine, n-propyldipropanolamine, N-butyldipropanolamine, N-methyldibutanolamine, N-ethyldibutanolamine, N-propyldibutanolamine, N-butyldibutanolamine, N-(aminomethyl)methanolamine, N-(aminomethyl)ethanolamine, N-(aminomethyl)propanolamine, N-(aminomethyl)butanolamine, N-(aminoethyl)methanolamine, N-(aminoethyl)ethanolamine, N-(aminoethyl)propanolamine, N-(aminoethyl)butanolamine, N-(aminopropyl)methanolamine, N-(aminopropyl)ethanolamine, N-(aminopropyl)propanolamine, N-(aminopropyl)butanolamine, N-(aminobutyl)methanolamine, N-(aminobutyl)ethanolamine, N-(aminobutyl)propanolamine and N-(aminobutyl)butanolamine.

Examples of the arylamines include aniline and N-methylaniline.
Examples of the organic amines other than the above amines include tetraalkylammonium hydroxides, such as tetramethylammonium hydroxide, tetraethylammonium hydroxide, tetrapropylammonium hydroxide and tetrabutylammonium hydroxide; tetraalkylethylenediamines, such as tetramethylethylenediamine, tetraethylethylenediamine, tetrapropylethylenediamine and tetrabutylethylenediamine; alkylaminoalkylamines, such as methylaminomethylamine, methylaminoethylamine, methylaminopropylamine, methylaminobutylamine, ethylaminomethylamine, ethylaminoethylamine, ethylaminopropylamine, ethylaminobutylamine, propylaminomethylamine, propylaminoethylamine, propylaminopropylamine, propylaminobutylamine, butylaminomethylamine, butylaminoethylamine, butylaminopropylamine and butylaminobutylamine; pyridine, pyrrole, piperazine, pyrrolidine, piperidine, picoline, morpholine, methylmorpholine, diazabicyclooctane, diazabicyclononane and diazabicycloundecene.

Such basic compounds may be used singly or may be used as a mixture of two or more kinds. Of these, triethylamine, tetramethylammonium hydroxide and pyridine are particularly preferable.

### Acidic compound

As the acidic compounds, organic acids and inorganic acids can be mentioned. Examples of the organic acids include acetic acid, propionic acid, butanoic acid, pentanoic acid, hexanoic acid, heptanoic acid, octanoic acid, nonanoic acid, decanoic acid, oxalic acid, maleic acid, maleic anhydride, methylmalonic acid, adipic acid, sebacic acid, gallic acid, butyric acid, mellitic acid, arachidonic acid, shikimic acid, 2-ethylhexanoic acid, oleic acid, stearic acid, linoleic acid, linolenic acid, salicylic acid, benzoic acid, p-aminobenzoic acid, p-toluenesulfonic acid, benzenesulfonic acid, monochloroacetic acid, dichloroacetic acid, trichloroacetic acid, trifluoroacetic acid, formic acid, malonic acid, methanesulfonic acid, phthalic acid, fumaric acid, citric acid and tartaric acid. Examples of the inorganic acids include hydrochloric acid, nitric acid, sulfuric acid, hydrofluoric acid and phosphoric acid.

Such acidic compounds may be used singly or may be used as a mixture of two or more kinds. Of these, maleic acid, maleic anhydride, methanesulfonic acid and acetic acid are particularly preferable.

### Metal chelate compound

As the metal chelate compounds, organometallic compounds and/or partial hydrolyzates thereof (organometallic compounds and/or partial hydrolyzates thereof being together referred to as "organometallic compounds" hereinafter) can be mentioned.

The organometallic compounds are, for example, compounds represented by the following formula (a):

M(OR⁷)ᵣ(R⁸COCHCOR⁹)ₛ (a)

wherein M is at least one metal atom selected from the group consisting of zirconium, titanium and aluminum, R⁷ and R⁸ are each independently a monovalent hydrocarbon group of 1 to 6 carbon atoms, such as methyl, ethyl, n-propyl, i-propyl, n-butyl, sec-butyl, t-butyl, n-pentyl, n-hexyl, cyclohexyl or phenyl, R⁹ is the above-mentioned monovalent hydrocarbon group of 1 to 6 carbon atoms or an alkoxyl group of 1 to 16 carbon atoms, such as methoxy, ethoxy, n-propoxy, i-propoxy, n-butoxy, sec-butoxy, t-butoxy, lauryloxy or stearyloxy, and r and z are each independently an integer of 0 to 4 and satisfy the relation of (r+s)=(valence of M) (said compounds being referred to as "organometallic compounds (a)" hereinafter),
tetravalent organometallic compounds of tin wherein 1 to 2 alkyl groups of 1 to 10 carbon atoms are bonded to one tin atom (referred to as "organotin compounds (a)" hereinafter), or partial hydrolyzates of the above compounds.

Examples of the organometallic compounds (a) include organozirconium compounds, such as tetra-n-butoxyzirconium, tri-n-butoxy·ethyl acetoacetate zirconium, di-n-butoxy·bis(ethyl acetoacetate)zirconium, n-butoxy·tris(ethyl acetoacetate) zirconium, tetrakis(n-propyl acetoacetate)zirconium, tetrakis(acetyl acetoacetate)zirconium and tetrakis(ethyl acetoacetate)zirconium; organotitanium compounds, such as tetra-i-propoxytitanium, di-i-propoxy·bis(ethyl acetoacetate)titanium, di-i-propoxy·bis(acetyl acetate)titanium and di-i-propoxy·bis(acetylacetone)titanium; and organoaluminum compounds, such as tri-i-propoxyaluminum, di-i-propoxy·ethyl acetoacetate aluminum, di-i-propoxy·acetylacetonatoaluminum, i-propoxy·bis(ethyl actoacetate)aluminum, i-propoxy·bis(acetylacetonato)aluminum, tris(ethyl acetoacetate)aluminum, tris(acetylacetonato)aluminum and monoacetylacetonato·bis(ethyl acetoacetate)aluminum.

Examples of the organotin compounds include:

carboxylic acid type organotin compounds, such as

(C₄H₉)₂Sn(OCOC₁₁H₂₃)₂,

(C₄H₉)₂Sn(OCOCH=CHCOOCH₃)₂,

(C₄H₉)₂Sn(OCOCH=CHCOOC₄H₉)₂,

(C₈H₁₇)₂Sn(OCOC₈H₁₇)₂,

(C₈H₁₇)₂Sn(OCOC₁₁H₂₃)₂,

(C₈H₁₇)₂Sn(OCOCH=CHCOOCH₃)₂,

(C₈H₁₇)₂Sn(OCOCH=CHCOOC₄H₉)₂,

(C₈H₁₇)₂Sn(OCOCH=CHCOOC₈H₁₇)₂,

(C₈H₁₇)₂Sn(OCOCH=CHCOOC₁₆H₃₃)₂,

(C₈H₁₇)₂Sn(OCOCH=CHCOOC₁₇H₃₅)₂,

(C₈H₁₇)₂Sn(OCOCH=CHCOOC₁₈H₃₇)₂,

(C₈H₁₇)₂Sn(OCOCH=CHCOOC₂₀H₄₁)₂,

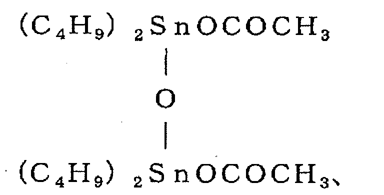

(C₄H₉)Sn(OCOC₁₁H₂₃)₃,

(C₄H₉)Sn(OCONa)₃ ;

mercaptide type organotin compounds, such as

(C₄H₉)₂Sn(SCH₂COOC₈H₁₇)₂,

(C₄H₉)₂Sn(SCH₂CH₂COOC₈H₁₇)₂,

(C₈H₁₇)₂Sn(SCH₂COOC₈H₁₇)₂,

(C₈H₁₇)₂Sn(SCH₂CH₂COOC₈H₁₇)₂,

(C₈H₁₇)₂Sn(SCH₂COOC₁₂H₂₅)₂,

(C₈H₁₇)₂Sn(SCH₂CH₂COOC₁₂H₂₅)₂,

(C₄H₉)Sn(SCOCH=CHCOOC₈H₁₇)₃,

(C₈H₁₇)Sn(SCOCH=CHCOOC₈H₁₇)₃,

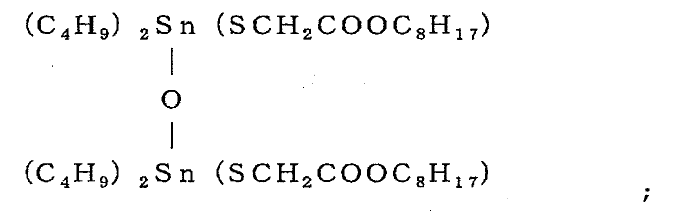

sulfide type organotin compounds, such as

(C₄H₉)₂Sn=S, (C₈H₁₇)₂Sn=S,

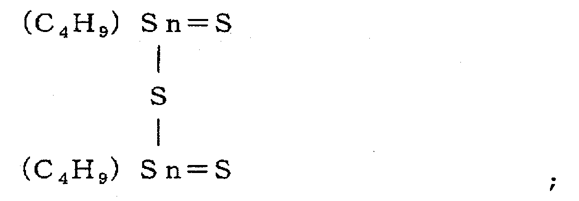

chloride type organotin compounds, such as

(C₄H₉)SnCl₃, (C₄H₉)₂SnCl₂,

(C₈H₁₇)₂SnCl₂,

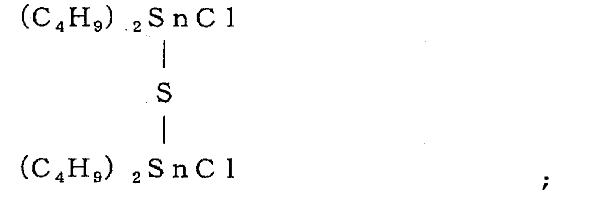

organotin oxides, such as (C₄H₉)₂SnO and (C₈H₁₇)₂SnO, and reaction products of these organotin oxides and ester compounds such as silicate, dimethyl maleate, diethyl maleatie and dioctyl phthalate.

Such metal chelate compounds may be used singly or may be used as a mixture of two or more kinds. Of these, tri-n-butoxy·ethyl acetoacetate zirconium, di-i-propoxy·bis(acetylacetonato)titanium, di-i-propoxy·ethyl acetoacetate aluminum, tris(ethyl acetoacetate) aluminum, and partial hydrolyzates of these compounds are preferable.

Of the basic compound, the acidic compound and the metal chelate compound, the metal chelate compound is preferable for the dealcoholization reaction from the viewpoint of excellent reactivity. In the dealcoholization reaction, the basic compound, the acidic compound or the metal chelate compound is added in an amount of usually 0.001 to 20 parts by weight, preferably 0.005 to 10 parts by weight, more preferably 0.01 to 5 parts by weight, based on 100 parts by weight of the total of the polyfunctional polysiloxane (b1) or (b3) and the polydimethylsiloxane (b2) or (b4).

In the hydrolysis/condensation reaction, the basic compound, the acidic compound or the metal chelate compound is added in an amount of usually 0.001 to 50 parts by weight, preferably 0.005 to 40 parts by weight, more preferably 0.01 to 30 parts by weight, based on 100 parts by weight of the total of the polyfunctional polysiloxane (b1) or (b3) and the polydimethylsiloxane (b2) or (b4).

The polyfunctional polysiloxane (B1) and (B2) obtained by the above process have a weight-average molecular weight, as measured by gel permeation chromatography, of usually 3,000 to 200,000, preferably 4,000 to 150,000, more preferably 5,000 to 100,000, in terms of polystyrene.

### Polyfunctional polysiloxane having hydroxyl group and/or alkoxy group

As the polyfunctional polysiloxane having a hydroxyl group and/or an alkoxy group, polyfunctional polysiloxane (B3) represented by the following average compositional formula (3) can be mentioned.

R¹ₐSiO_{b}(OR³)_{c} (3)

In the formula (3), R¹ is defined similarly to R¹ in the formula (1), R³ is a hydrogen atom or an alkyl group, when plural R³ are present, they may be the same as or different from one another, a is more than 0 but less than 2, b is more than 0 but less than 2, c is more than 0 but less than 4, and a+b×2+c=4. When plural R¹ and plural R³ are present, a indicates a ratio of the total of hydrogen atoms and monovalent hydrocarbon groups having no oxyalkylene group to silicon atoms, and c indicates a ratio of the total of hydroxyl groups and alkoxy groups to silicon atoms.

The weight-average molecular weight of the polyfunctional polysiloxane (B3), as measured by gel permeation chromatography, is in the range of preferably 1,000 to 100,000, more preferably 1,000 to 80,000, particularly preferably 1,500 to 70,000, in terms of polystyrene. When the polyfunctional polysiloxane (B3) having a weight-average molecular weight of the above range is used, inhibition of occurrence of a crack and excellent curability can be reconciled in the formation of a cured product.

Although the monovalent hydrocarbon group is not specifically restricted provided that it has no oxyalkylene group, a substituted or unsubstituted monovalent hydrocarbon group can be mentioned as the monovalent hydrocarbon group. Examples of the substituted or unsubstituted monovalent hydrocarbon groups include the same subsitututed or unsubstituted monovalent hydrocarbon groups as previously described for the alkoxy-terminated polyfunctional polysiloxane (b1).

Examples of the alkyl groups indicated by R³ include the same alkyl groups as previously described for the alkoxy-terminated polyfunctional polysiloxane (b1), and preferable are methyl and ethyl.

The polyfunctional polysiloxane (B3) can be prepared by, for example, properly combining polyfunctional alkoxysilanes or polyfunctional chlorosilanes so as to satisfy the aforesaid average compositional formula and subjecting them to hydrolysis/condensation. However, hydrolysis/condensation of tetraalkoxysilanes only and hydrolysis/condensation of dialkoxysilanes only are excluded.

Examples of the polyfunctional alkoxysilanes include the same polyfunctional alkoxysilanes as previously described for the alkoxy-terminated polyfunctional polysiloxane (b1), and they can be used singly or as a mixture of two or more kinds.

Also for the polyfunctional polysiloxane (B3), the same monofunctional alkoxysilanes as previously described for the alkoxy-terminated polyfunctional polysiloxane (b1) can be used in combination with the polyfunctional alkoxysilanes. In this case, the monofunctional alkoxysilanes are desirably used in amounts of not more than 10% by weight, preferably not more than 7% by weight, more preferably not more than 5% by weight, based on the total amount of the alkoxysilanes used.

As the alkoxy group-containing polysiloxanes, commercially available siloxane polymers, such as X40-9290 and X40-9225 (trade names) available from Shin-Etsu Silicone Co., Ltd. and XR31-B1410, XR31-B0270 and XR31-B2733 (trade names) available from GE Toshiba Silicone Co., Ltd., are also employable.

### Oxide fine particle-containing polysiloxane composition and uses thereof

The oxide fine particle-containing polysiloxane composition of the invention can be obtained by mixing the oxide fine particles (A) with the polyfunctional polysiloxane (B1), (B2) or (B3) in an organic solvent in the presence of a basic compound, an acidic compound or a metal chelate compound and thereby performing dispersing treatment, without using phosphoric acid or the like having an organic group of 6 or more carbon atoms or a compound having an oxyalkylene group.

### Organic solvent

Examples of the organic solvents include the same organic solvents as previously described for the dealcoholization reaction or the hydrolysis/condensation reaction in the preparation of the polyfunctional polysiloxane (B1) or (B2). These organic solvents may be used singly or may be used as a mixture of two or more kinds. Of these organic solvents, organic solvents other than alcohols, such as methyl ethyl ketone, methyl isobutyl ketone, diisobutyl ketone, toluene, xylene, ethyl acetate and butyl acetate, and mixtures thereof are preferable from the viewpoint that dispersion stability and high viscosity of the oxide fine particle-containing polysiloxane composition can be obtained. These organic solvents are preferably subjected to dehydration treatment to remove water content prior to use.

Although the amount of the organic solvent used is not specifically restricted provided that the oxide fine particles (A) can be homogeneously dispersed, the organic solvent is used in such an amount that the solids concentration of the resulting oxide fine particle-containing polysiloxane composition becomes preferably 5 to 80% by weight, more preferably 7 to 70% by weight, particularly preferably 10 to 60% by weight.

### Basic compound, acidic compound and metal chelate compound

Examples of the basic compounds, the acidic compounds and the metal chelate compounds include the same compounds as previously described for the dealcoholization reaction or the hydrolysis/condensation reaction in the preparation of the polyfunctional polysiloxane (B1) or (B2). Of these basic compounds, acidic compounds and metal chelate compounds, preferable are the basic compounds and the acidic compounds, more preferable are the basic compounds, still more preferable are organic amine compounds, and particularly preferable are triethylamine, tetramethylammonium hydroxide and pyridine.

In the oxide fine particle-containing polysiloxane composition of the invention, the basic compound, the acidic compound or the metal chelate compound is desirably contained in an amount of usually 0.001 to 20 parts by weight, preferably 0.005 to 10 parts by weight, more preferably 0.01 to 5 parts by weight, still more preferably 0.01 to 1 part by weight, particularly preferably 0.01 to 0.5 part by weight, based on 100 parts by weight of the oxide fine particles (A). When the amount of the above compound is in the above range, dispersion stability of the oxide fine particles (A) and viscosity of the oxide fine particle-containing polysiloxane composition can be readily controlled.

### Process for preparing oxide fine particle-containing polysiloxane composition

The oxide fine particle-containing polysiloxane composition can be prepared by adding the oxide fine particles (A), the polyfunctional polysiloxane (B1), (B2) or (B3), and the basic compound, the acidic compound or the metal chelate compound to the organic solvent, then sufficiently mixing them and thereby dispersing the oxide fine particles (A) in the organic solvent. In this preparation, it is preferable to use a publicly known dispersing machine, such as ball mill, sand mill (bead mill, high shear bead mill), homogenizer, ultrasonic homogenizer, nanomizer, propeller mixer, high shear mixer or paint shaker. In order to prepare a dispersion of particularly highly dispersed fine particles, a ball mill or a sand mill (bead mill, high shear bead mill) is preferably used. It is presumed that when the oxide fine particles (A) and the polyfunctional polysiloxane (B1), (B2) or (B3) are mixed in the presence of the basic compound, the acidic compound or the metal chelate compound as described above, condensation reaction of the polyfunctional polysilixane (B1), (B2) or (B3) proceeds on the surfaces of the oxide fine particles (A) by virtue of the catalytic action of the basic compound, the acidic compound or the metal chelate compound, whereby the surfaces of the oxide fine particles (A) become hydrophobic, and the oxide fine particles (A) tend to be finely dispersed in the organic solvent.

In the oxide fine particle-containing polysiloxane composition of the invention, the polyfunctional polysiloxane (B1), (B2) or (B3) is desirably contained in an amount of preferably 1 to 1000 parts by weight, more preferably 5 to 900 parts by weight, particularly preferably 10 to 800 parts by weight, in terms of a perfect hydrolysis condensate, based on 100 parts by weight of the oxide fine particles (A).

The oxide fine particle-containing polysiloxane composition is a composition in which the oxide fine particles (A) having a volume-average dispersed particle diameter of preferably not more than 300 nm, more preferably not more than 200 nm, are highly dispersed. Further, it is preferable that the oxide fine particle-containing polysiloxane composition does not substantially contain water, and more specifically, this composition has a water content of preferably not more than 5% by weight, more preferably not more than 3% by weight, particularly preferably not more than 1% by weight.

The viscosity of the oxide fine particle-containing polysiloxane composition of the invention can be increased by extending the dispersing time without using an organic thickening agent such as polyethylene glycol. Moreover, gelation and sedimentation of the oxide fine particles (A) do not occur, and even in the case where an additive of high specific gravity is mixed, sedimentation separation can be inhibited.

The oxide fine particle-containing polysiloxane composition has a viscosity, as measured by a RE80 model viscometer manufactured by Toki Sangyo Co., Ltd. under the conditions of a temperature of 25°C, a rotor rotational speed of 5 rpm and a solids concentration of 20% by weight, of preferably not less than 20 mPa·s, more preferably not less than 30 mPa·s, particularly preferably not less than 50 mPa·s. When the viscosity of the oxide fine particle-containing polysiloxane composition is in the above range, separation does not occur even if a filler of high specific gravity is added, and a cured product of a large film thickness can be readily produced.

When the oxide fine particle-containing polysiloxane composition contains the oxide fine particles (A) and the polyfunctional polysiloxane (B1) or (B2) having a dimethylsiloxane chain, a cured product having a thickness of 10 µm to 1 mm can be also formed because the polyfunctional polysiloxanes (B1) and (B2) have excellent flexibility.

Moreover, because the polyfunctional polysiloxane (B1) and (B2) have plural terminal alkoxy groups or the polyfunctional polysiloxane (B3) has plural hydroxyl groups or alkoxy groups, the oxide fine particles (A) are highly dispersed in the composition without using phosphoric acid or the like having an organic group of 6 or more carbon atoms or a compound having an oxyalkylene group. By virtue of this, a cured product (film) which is not deteriorated even if it is exposed to severe environment and which has excellent transparency can be formed. This cured product can be obtained by applying the oxide fine particle-containing polysiloxane composition onto a substrate or the like, then drying it to remove the solvent and thereby curing the polyfunctional polysiloxane. This cured product does not have a carbon-carbon bond in the crosslinked structure, and is excellent also in ultraviolet light resistance. For example, the cured product is not yellowed (does not turn yellow) even by irradiation with ultraviolet light at 5000 mW/m² for 200 hours. Moreover, the cured product is not thermally deteriorated even by heating at 150°C for 200 hours.

The oxide fine particle-containing polysiloxane composition of the invention can further contain a fluorescent substance, and a cured product of such a composition can be used as an LED sealing material. The oxide fine particle-containing polysiloxane composition of the invention may further contain glass fibers in order to relax shrinkage/expansion of a cured product. When a composition containing glass fibers is used, a cured product of a larger film thickness can be formed. In order to secure transparency of a cured product, a difference in refractive index between the polyfunctional polysiloxane (B1) or (B2) and the glass fibers is preferably not more than 0.01.

### EXAMPLES

The present invention is further described with reference to the following examples, but it should be construed that the invention is in no way limited to those examples. The terms "part(s)" and "%" in the examples and the comparative examples mean "part(s) by weight" and "% by weight", respectively, unless otherwise noted.

### Composition containing polyfunctional polysiloxane (B1) or (B2)

Various measurements in the examples and the comparative examples were carried out by the following methods.

### GPC measurement

Weight-average molecular weight of siloxane is indicated by a value in terms of polystyrene measured by gel permeation chromatography under the following conditions.
Apparatus: HLC-8120C (manufactured by Tosoh Corporation)
Column: TSK-gel MultiporeH_{XL}-M (manufactured by Tosoh Corporation)
Eluting solution: THF, flow rate: 0.5 mL/min, load: 5.0%, 100 µL

### Dispersibility

Appearance of the resulting composition was visually observed. Volume-average dispersed particle diameter of fine particles in a composition in which sedimentation of fine particles was not observed was measured by a microtrack ultrafine particle size distribution meter ("UPA150" manufactured by Nikkiso Co., Ltd.), and the composition was evaluated by the following criteria.
A: The composition is free from separation sedimentation. Volume-average dispersed particle diameter≤200nm
B: The composition is free from separation sedimentation. 200nm<Volume-average dispersed particle diameter≤300nm
C: The composition is free from separation sedimentation. 300nm<Volume-average dispersed particle diameter
D: The composition suffers separation sedimentation.

### Thick film-forming properties

The resulting composition was applied onto a quartz glass plate so that the dry film thickness would become 50 µm, thereafter dry cured at 100°C for 1 hour and then further dry cured at 200°C for 1 hour to prepare a cured product having a film thickness of 50 µm on the quartz glass plate. Then, appearance of the cured product was visually observed, and the cured product was evaluated by the following criteria.
A: The cured product is free from a crack.
B: The cured product suffers occurrence of a crack.

### Coating film transparency

The resulting composition was applied onto a quartz glass plate so that the dry film thickness would become 20 µm, thereafter dry cured at 100°C for 1 hour and then further dry cured at 200°C for 1 hour to prepare a cured product having a film thickness of 20 µm on the quartz glass plate. Then, spectral transmittance of the cured product at a wavelength of 500 to 700 nm was measured by an ultraviolet visible spectrophotometer, and the cured product was evaluated by the following criteria.
A: Light transmittance is more than 90%.
B: Light transmittance is not less than 85% but not more than 90%.
C: Light transmittance is not less than 70& but less than 85%.
D: Light transmittance is less than 70%.

### Yellowness

The resulting composition was applied onto a quartz glass plate so that the dry film thickness would become 20 µm, thereafter dry cured at 100°C for 1 hour and then further dry cured at 200°C for 1 hour to prepare a cured product having a film thickness of 20 µm on the quartz glass plate. Then, light transmittance of the cured product at a wavelength of 450 nm was measured by an ultraviolet visible spectrophotometer, and the cured product was evaluated by the following criteria.
A: Light transmittance is more than 90%.
B: Light transmittance is 70 to 90%.
C: Light transmittance is less than 70%.

### Preparation Example A1

In a reactor equipped with a stirrer and a reflux condenser, 14 parts by weight of alkoxy-terminated polysiloxane having Mw of 1,000 (available from Shin-Etsu Chemical Co., Ltd., trade name: X40-9220), 86 parts by weight of hydroxy-terminated polydimethylsiloxane having Mw of 20,000 (available from GE Toshiba Silicone Co., Ltd., trade name: XF-3905), 42 parts by weight of toluene and 0.2 part by weight of an isopropyl alcohol 75% dilute solution of di-i-propoxy·ethyl acetoacetate aluminum were placed and mixed, and dealcoholization reaction was carried out at 70°C for 3 hours with stirring. Subsequently, 53 parts by weight of methyl isobutyl ketone, 53 parts by weight of toluene and 0.6 part by weight of water were added, and hydrolysis/condensation reaction was carried out at 70°C for 3 hours to obtain a polysiloxane solution (I) containing polyfunctional polysiloxane of Mw of 26,000 and having a solids concentration of 40% by weight.

### Preparation Example A2

A polysiloxane solution (II) containing polyfunctional polysiloxane of Mw of 24,000 and having a solids concentration of 40% by weight was obtained in the same manner as in Preparation Example A1, except that 7 parts by weight of an alkoxy-terminated siloxane oligomer having Mw of 800 (available from GE Toshiba Silicone Co., Ltd., trade name: XC96-B0446) were used instead of the alkoxy-terminated polysiloxane having Mw of 1,000 (X40-9220), and the amount of the hydroxy-terminated polydimethylsiloxane having Mw of 20,000 (XF-3905) was changed to 93 parts by weight.

### Preparation Example A3

In a reactor equipped with a stirrer and a reflux condenser, 7 parts by weight of alkoxy-terminated polysiloxane having Mw of 800 (available from GE Toshiba Silicone Co., Ltd., trade name: XC96-B0446), 93 parts by weight of hydroxy-terminated polydimethylsiloxane having Mw of 20,000 (available from GE Toshiba Silicone Co., Ltd., trade name: XF-3905), 42 parts by weight of toluene and 0.2 part by weight of an isopropyl alcohol 75% dilute solution of di-i-propoxy·ethyl acetoacetate aluminum were placed and mixed, and dealcoholization reaction was carried out at 70°C for 3 hours with stirring. To the resulting reaction solution were added 53 parts by weight of methyl isobutyl ketone and 53 parts by weight of toluene to obtain a polysiloxane solution (III) containing polyfunctional polysiloxane of Mw of 23,000 and having a solids concentration of 40% by weight.

### Preparation Example A4

A polysiloxane solution (i) containing polyfunctional polysiloxane of Mw of 30,000 and having a solids concentration of 40% by weight was obtained in the same manner as in Preparation Example A1, except that the amount of the alkoxy-terminated siloxane oligomer (X40-9220) was changed to 60 parts by weight, and the amount of the hydroxy-terminated polydimethylsiloxane (XF-3905) was changed to 40 parts by weight.

### Example A1

In a container, 100 parts by weight of powdery rutile titanium oxide fine particles (average primary particle diameter: 30 nm), 250 parts by weight (100 parts by weight in terms of solid matter) of the polysiloxane solution (I) as a polysiloxane component, 0.1 part by weight of triethylamine and 650 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (A-1) having a solids concentration of 20% by weight was obtained. The results of evaluation of properties of this composition are set forth in Table A1.

### Example A2

A metal oxide fine particle-containing polysiloxane composition (A-2) having a solids concentration of 20% by weight was prepared in the same manner as in Example A1, except that 0.1 part by weight of methanesulfonic acid was used instead of triethylamine. The results of evaluation of properties of this composition are set forth in Table A1.

### Example A3

A metal oxide fine particle-containing polysiloxane composition (A-3) having a solids concentration of 20% by weight was prepared in the same manner as in Example A1, except that 100 parts by weight of powdery zinc oxide fine particles (average primary particle diameter: 20 nm) were used instead of the rutile titanium oxide fine particles, and 250 parts by weight (100 parts by weight in terms of solid matter) of the polysiloxane solution (II) were used instead of the polysiloxane solution (I). The results of evaluation of properties of this composition are set forth in Table A1.

### Example A4

A metal oxide fine particle-containing polysiloxane composition (A-4) having a solids concentration of 20% by weight was prepared in the same manner as in Example A1, except that 100 parts by weight of powdery zirconium oxide fine particles (average primary particle diameter: 20 nm) were used instead of the rutile titanium oxide fine particles. The results of evaluation of properties of this composition are set forth in Table A1.

### Example A5

A metal oxide fine particle-containing polysiloxane composition (A-5) having a solids concentration of 20% by weight was prepared in the same manner as in Example A4, except that 250 parts by weight (100 parts by weight in terms of solid matter) of the polysiloxane solution (III) were used instead of the polysiloxane solution (I). The results of evaluation of properties of this composition are set forth in Table A1.

### Comparative Example A1

In a container, 100 parts by weight of powdery rutile titanium oxide fine particles (average primary particle diameter: 30 nm), 100 parts by weight of hydroxy-terminated polydimethylsiloxane having Mw of 20,000 (available from GE Toshiba Silicone Co., Ltd., trade name: XF-3905), 0.1 part by weight of triethylamine and 800 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (A-C1) having a solids concentration of 20% by weight was obtained. The results of evaluation of properties of this composition are set forth in Table A1.

### Comparative Example A2

A metal oxide fine particle-containing polysiloxane composition (A-C2) having a solids concentration of 20% by weight was prepared in the same manner as in Example A1, except that 250 parts by weight of the polysiloxane solution (i) were used instead of the polysiloxane solution (I) as a polysiloxane component. The results of evaluation of properties of this composition are set forth in Table A1.

### Comparative Example A3

A metal oxide fine particle-containing polysiloxane composition (A-C3) having a solids concentration of 20% by weight was prepared in the same manner as in Example A1, except that triethylamine was not used. The results of evaluation of properties of this composition are set forth in Table A1.

### Comparative Example A4

In a container, 100 parts by weight of powdery rutile titanium oxide fine particles (average primary particle diameter: 30 nm), 250 parts by weight (100 parts by weight in terms of solid matter) of the polysiloxane solution (I) as a polysiloxane component, 9 parts by weight of a polyoxyethylene alkylphosphoric ester (available from Kusumoto Chemicals, Ltd., trade name: PLADD ED151), 5 parts by weight of acetylacetone and 650 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (A-C4) having a solids concentration of 20% by weight was obtained. The results of evaluation of properties of this composition are set forth in Table A1.

### Comparative Example A5

A metal oxide fine particle-containing polysiloxane composition (A-C5) having a solids concentration of 20% by weight was prepared in the same manner as in Comparative Example A4, except that 100 parts by weight of powdery zinc oxide fine particles (average primary particle diameter: 20 nm) were used instead of the rutile titanium oxide fine particles. The results of evaluation of properties of this composition are set forth in Table A1.

### Comparative Example A6

A metal oxide fine particle-containing polysiloxane composition (A-C5) having a solids concentration of 20% by weight was prepared in the same manner as in Comparative Example A4, except that 100 parts by weight of powdery zirconium oxide fine particles (average primary particle diameter: 20 nm) were used instead of the rutile titanium oxide fine particles. The results of evaluation of properties of this composition are set forth in Table A1.

Table A1

**Table A1**

| | Ex.A1 | Ex. A2 | Ex. A3 | EX. A4 | Ex. A5 | Comp. Ex. A1 | Comp. Ex. A2 | Comp. Ex. A3 | Comp. Ex. A4 | Comp. Ex. A5 | Comp. Ex. A6 |
|---|---|---|---|---|---|---|---|---|---|---|---|
| Metal oxide fine particles | rutile titanium oxide | | zinc oxide | zirconium oxide | | rutile titanium oxide | | | | zinc oxide | zirconium oxide |
| Polysiloxane solution | (I) | (I) | (II) | (I) | (III) | XF-3905 | (i) | (I) | | (I) | (I) |
| Additives | triethylamine | methanesulfonic acid | triethylamine | | | triethylamine | | - | PLADD ED151 acetylacetone | | |
| Dispersibility | A | A | A | A | A | D | A | D | A | A | A |
| Thick film-forming properties | A | A | A | A | A | - | B | - | A | A | A |
| Coating film transparency | A | A | A | A | B | - | occurrence of crack in baking at 200°C | - | D | D | D |
| Yellowness | A | A | A | A | A | - | | - | C | C | C |

### Composition containing polyfunctional polysiloxane (B3)

Various measurements in the examples and the comparative examples were carried out by the following methods.

### GPC measurement

Weight-average molecular weight of siloxane is indicated by a value in terms of polystyrene measured by gel permeation chromatography under the following conditions.
Apparatus: HLC-8120C (manufactured by Tosoh Corporation)
Column: TSK-gel MultiporeH_{XL}-M (manufactured by Tosoh Corporation)
Eluting solution: THF, flow rate: 0.5 mL/min, load: 5.0%, 100 µL

### Dispersibility

Appearance of the resulting composition was visually observed. Volume-average dispersed particle diameter of fine particles in a composition in which sedimentation of fine particles was not observed was measured by a microtrack ultrafine particle size distribution meter ("UPA150" manufactured by Nikkiso Co., Ltd.), and the composition was evaluated by the following criteria.
A: The composition is free from separation sedimentation. Volume-average dispersed particle diameter≤200nm
B: The composition is free from separation sedimentation. 200nm<Volume-average dispersed particle diameter≤300nm
C: The composition is free from separation sedimentation. 300nm<Volume-average dispersed particle diameter
D: The composition suffers separation sedimentation.

### Coating film transparency

The resulting composition was applied onto a quartz glass plate so that the dry film thickness would become 2 µm, thereafter dry cured at 100°C for 1 hour and then further dry cured at 200°C for 1 hour to prepare a cured product having a film thickness of 2 µm on the quartz glass plate. Then, spectral transmittance of the cured product at a wavelength of 500 to 700 nm was measured by an ultraviolet visible spectrophotometer, and the cured product was evaluated by the following criteria.
A: Light transmittance is more than 90%.
B: Light transmittance is 70 to 90%.
C: Light transmittance is less than 70%.

### Yellowness

The resulting composition was applied onto a quartz glass plate so that the dry film thickness would become 2 µm, thereafter dry cured at 100°C for 1 hour and then further dry cured at 200°C for 1 hour to prepare a cured product having a film thickness of 2 µm on the quartz glass plate. Then, light transmittance of the cured product at a wavelength of 450 nm was measured by an ultraviolet visible spectrophotometer, and the cured product was evaluated by the following criteria.
A: Light transmittance is more than 90%.
B: Light transmittance is 70 to 90%.
C: Light transmittance is less than 70%.

### Ultraviolet light resistance

The composition was applied onto a quartz glass plate so that the dry film thickness would become 2 µm, thereafter dry cured at 100°C for 1 hour and then further dry cured at 200°C for 1 hour to form a cured product having a film thickness of 2 µm on the quartz glass plate. The cured product was irradiated with ultraviolet light for 200 hours by the use of a spot UV irradiation apparatus ("SP-V" manufactured by Ushio Inc.) under the conditions of an ultraviolet illuminance of 5000 mW/cm² at a wavelength of 365 nm. Thereafter, appearance of the film was visually observed, and the film was evaluated by the following criteria.
A: The film is not colored. The film is free from a crack.
B: The film is slightly colored. The film is free from a crack.
C: The film is colored. The film is free from a crack.
D: The film is colored. The film suffers occurrence of a crack.

### Example B1

In a container, 100 parts by weight of powdery rutile titanium oxide fine particles (average primary particle diameter: 30 nm), 100 parts by weight of an alkoxy-terminated methyl-based silicone oligomer having Mw of 2,000 (available from Shin-Etsu Chemical Co., Ltd., trade name: X40-9225) as polyfunctional polysiloxane, 0.1 part by weight of triethylamine and 700 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (B-1) having a solids concentration of 20% by weight was obtained. The results of evaluation of properties of this composition are set forth in Table B1.

### Example B2

A metal oxide fine particle-containing polysiloxane composition (B-2) having a solids concentration of 20% by weight was prepared in the same manner as in Example B1, except that 100 parts by weight of powdery zinc oxide fine particles (average primary particle diameter: 20 nm) were used instead of the rutile titanium oxide fine particles, and 0.1 part by weight of pyridine was used instead of triethylamine. The results of evaluation of properties of this composition are set forth in Table B1.

### Example B3

A metal oxide fine particle-containing polysiloxane composition (B-3) having a solids concentration of 20% by weight was prepared in the same manner as in Example B1, except that 100 parts by weight of powdery zirconium oxide fine particles (average primary particle diameter: 20 nm) were used instead of the rutile titanium oxide fine particles. The results of evaluation of properties of this composition are set forth in Table B1.

### Example B4

A metal oxide fine particle-containing polysiloxane composition (B-4) having a solids concentration of 20% by weight was prepared in the same manner as in Example B1, except that 100 parts by weight of an alkoxy-terminated methyl-based silicone polymer having Mw of 10,000 (available from GE Toshiba Silicone Co., Ltd., trade name: XR31-B2733) were used instead of the silicone oligomer (X40-9225) as polyfunctional polysiloxane. The results of evaluation of properties of this composition are set forth in Table B1.

### Comparative Example B1

In a container, 100 parts by weight of powdery rutile titanium oxide fine particles (average primary particle diameter: 30 nm), 100 parts by weight of an alkoxy-terminated methyl-based silicone oligomer having Mw of 2,000 (available from Shin-Etsu Chemical Co., Ltd., trade name: X40-9225) as polyfunctional polysiloxane, 9 parts by weight of a polyoxyethylene alkylphosphoric ester (available from Kusumoto Chemicals, Ltd., trade name: PLADD ED151), 5 parts by weight of acetylacetone and 700 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (B-a) having a solids concentration of 20% by weight was obtained. The results of evaluation of properties of this composition are set forth in Table B1.

### Comparative Example B2

Powdery rutile titanium oxide fine particles were dispersed in methyl ethyl ketone in the same manner as in Example B1, except that triethylamine was not used. However, the titanium oxide fine particles were sedimented.

### Comparative Example B3

Powdery rutile titanium oxide fine particles were dispersed in methyl ethyl ketone in the same manner as in Example B1, except that polyfunctional polysiloxane was not used. However, the titanium oxide fine particles were sedimented.

### Comparative Example B4

Powdery rutile titanium oxide fine particles were dispersed in methyl ethyl ketone in the same manner as in Example B1, except that polydimethylsiloxane containing no Si-OR bond (R is an alkyl group) and no Si-OH bond and having methacrylic structures at both ends (available from Shin-Etsu Chemical Co., Ltd., trade name: X-22-164B) was used instead of the polyfunctional polysiloxane. However, the titanium oxide fine particles were sedimented.

### Comparative Example B5

In a container, 300 parts by weight of a titanium oxide fine particle water dispersion wherein anatase titanium oxide fine particles had been beforehand dispersed in water ("STS-01" available from Ishihara Sangyo Kaisha, Ltd., TiO₂ concentration: 30% by weight, volume-average dispersed particle diameter of titanium oxide fine particles: 60 nm, organic dispersing agent: 0% by weight) were placed, and thereto were added 100 parts by weight of an alkoxy-terminated methyl-based silicone oligomer (available from Shin-Etsu Chemical Co., Ltd., trade name: X40-9225) and 500 parts by weight of methyl ethyl ketone. To this mixture, 2000 parts by weight of zirconia beads of 0.1 mm diameter were further added, and they were stirred by the use of a bead mill at 1500 rpm for 1 hour to disperse the fine particles. However, the titanium oxide fine particles were sedimented.

### Comparative Example B6

In a container, 300 parts by weight of a titanium oxide fine particle water dispersion ("STS-01" available from Ishihara Sangyo Kaisha, Ltd.) were placed, and thereto were added 200 parts by weight of a condensate of only a tetrafunctional silane compound (available from Colcoat Co., Ltd., trade name: Ethyl Silicate 48) and 500 parts by weight of methyl ethyl ketone. To this mixture, 2000 parts by weight of zirconia beads of 0.1 mm diameter were further added, and they were stirred by the use of a bead mill at 1500 rpm for 1 hour to disperse the fine particles. However, the titanium oxide fine particles were sedimented.

### Comparative Example B7

A metal oxide fine particle-containing polysiloxane composition (B-e) was prepared by dispersing titanium oxide fine particles in the same manner as in Comparative Example B6, except that methyl ethyl ketone was replaced with 500 parts by weight of isopropyl alcohol. In this composition, the titanium oxide fine particles were favorably dispersed, but a crack occurred in the production of a film.

**Table B1**

| | Ex. B1 | Ex. B2 | Ex. B3 | EX. B4 | Comp. Ex. B1 | Comp. Ex. B2 | Comp. Ex. B3 | Comp. Ex. B4 | Comp. Ex. B5 | Comp. Ex. B6 | Comp. Ex. B7 |
|---|---|---|---|---|---|---|---|---|---|---|---|
| Oxide fine particles | rutile titanium oxide | zinc oxide | zirconium oxide | rutile titanium oxide | rutile titanium oxide | | | | TiO₂ fine particle water dispersion | | |
| Polysiloxane | X40-9225 | | | XR31- B2733 | X40-9225 | | - | X-22-164B | X40-9225 | Condensate of tetrafunctional silane | |
| Additives | triethylamine | pyridine | triethylamine | | PLADD ED151 acetylacetone | - | triethylamine | triethylamine | - | - | - |
| Organic solvent | methyl ethyl ketone | | | | | | | | | | isopropyl alcohol |
| Dispersibility | A | A | A | A | A | D | D | D | D | D | A |
| Coating film transparency | A | A | A | A | C | - | - | - | - | - | occurrence of crack in film production |
| Yellowness | A | A | A | A | C | - | - | - | - | - | |
| Ultraviolet light resistance | A | A | A | A | C | - | - | - | - | - | |

### Example C1

In a container, 100 parts by weight of powdery rutile titanium oxide fine particles (average primary particle diameter: 30 nm), 100 parts by weight of an alkoxy-terminated methyl-based silicone oligomer having Mw of 2,000 (available from Shin-Etsu Chemical Co., Ltd., trade name: X40-9225) as polyfunctional polysiloxane, 0.1 part by weight of methanesulfonic acid and 700 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (C-1) having a solids concentration of 20% by weight was obtained. The results of evaluation of properties of this composition are set forth in Table C1.

### Example C2

A metal oxide fine particle-containing polysiloxane composition (C-2) having a solids concentration of 20% by weight was prepared in the same manner as in Example C1, except that 100 parts by weight of powdery zinc oxide fine particles (average primary particle diameter: 20 nm) were used instead of the rutile titanium oxide fine particles, and 0.1 part by weight of acetic acid was used instead of methanesulfonic acid. The results of evaluation of properties of this composition are set forth in Table C1.

### Example C3

A metal oxide fine particle-containing polysiloxane composition (C-3) having a solids concentration of 20% by weight was prepared in the same manner as in Example C1, except that 100 parts by weight of powdery zirconium oxide fine particles (average primary particle diameter: 20 nm) were used instead of the rutile titanium oxide fine particles. The results of evaluation of properties of this composition are set forth in Table C1.

### Example C4

A metal oxide fine particle-containing polysiloxane composition (C-4) having a solids concentration of 20% by weight was prepared in the same manner as in Example C1, except that 100 parts by weight of an alkoxy-terminated methyl-based silicone polymer having Mw of 10,000 (available from GE Toshiba Silicone Co., Ltd., trade name: XR31-B2733) were used instead of the silicone oligomer (X40-9225) as polyfunctional polysiloxane. The results of evaluation of properties of this composition are set forth in Table C1.

### Comparative Example C1

In a container, 100 parts by weight of powdery rutile titanium oxide fine particles (average primary particle diameter: 30 nm), 100 parts by weight of an alkoxy-terminated methyl-based silicone oligomer having Mw of 2,000 (available from Shin-Etsu Chemical Co., Ltd., trade name: X40-9225) as polyfunctional polysiloxane, 9 parts by weight of a polyoxyethylene alkylphosphoric ester (available from Kusumoto Chemicals, Ltd., trade name: PLADD ED151), 5 parts by weight of acetylacetone and 700 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (C-a) having a solids concentration of 20% by weight was obtained. The results of evaluation of properties of this composition are set forth in Table C1.

### Comparative Example C2

Powdery rutile titanium oxide fine particles were dispersed in methyl ethyl ketone in the same manner as in Example C1, except that methanesulfonic acid was not used. However, the titanium oxide fine particles were sedimented.

### Comparative Example C3

Powdery rutile titanium oxide fine particles were dispersed in methyl ethyl ketone in the same manner as in Example C1, except that polyfunctional polysiloxane was not used. However, the titanium oxide fine particles were sedimented.

### Comparative Example C4

Powdery rutile titanium oxide fine particles were dispersed in methyl ethyl ketone in the same manner as in Example C1, except that polydimethylsiloxane containing no Si-OR bond (R is an alkyl group) and no Si-OH bond and having methacrylic structures at both ends (available from Shin-Etsu Chemical Co., Ltd., trade name: X-22-164B) was used instead of the polyfunctional polysiloxane. However, the titanium oxide fine particles were sedimented.

### Comparative Example C5

In a container, 300 parts by weight of a titanium oxide fine particle water dispersion wherein anatase titanium oxide fine particles had been beforehand dispersed in water ("STS-01" available from Ishihara Sangyo Kaisha, Ltd., TiO₂ concentration: 30% by weight, volume-average dispersed particle diameter of titanium oxide fine particles: 60 nm, organic dispersing agent: 0% by weight) were placed, and thereto were added 100 parts by weight of an alkoxy-terminated methyl-based silicone oligomer (available from Shin-Etsu Chemical Co., Ltd., trade name: X40-9225) and 500 parts by weight of methyl ethyl ketone. To this mixture, 2000 parts by weight of zirconia beads of 0.1 mm diameter were further added, and they were stirred by the use of a bead mill at 1500 rpm for 1 hour to disperse the fine particles. However, the titanium oxide fine particles were sedimented.

### Comparative Example C6

In a container, 300 parts by weight of a titanium oxide fine particle water dispersion ("STS-01" available from Ishihara Sangyo Kaisha, Ltd.) were placed, and thereto were added 200 parts by weight of a condensate of only a tetrafunctional silane compound (available from Colcoat Co., Ltd., trade name: Ethyl Silicate 48) and 500 parts by weight of methyl ethyl ketone. To this mixture, 2000 parts by weight of zirconia beads of 0.1 mm diameter were further added, and they were stirred by the use of a bead mill at 1500 rpm for 1 hour to disperse the fine particles. However, the titanium oxide fine particles were sedimented.

### Comparative Example C7

A metal oxide fine particle-containing polysiloxane composition (C-e) was prepared by dispersing titanium oxide fine particles in the same manner as in Comparative Example C6, except that methyl ethyl ketone was replaced with 500 parts by weight of isopropyl alcohol. In this composition, the titanium oxide fine particles were favorably dispersed, but a crack occurred in the production of a film.

**Table C1**

| | Ex. C1 | Ex. C2 | Ex. C3 | EX. C4 | Comp. Ex. C1 | Comp. Ex. C2 | Comp. Ex. C3 | Comp. Ex. C4 | Comp. Ex. C5 | Comp. Ex. C6 | Comp. Ex. C7 |
|---|---|---|---|---|---|---|---|---|---|---|---|
| Oxide fine particles | rutile titanium oxide | zinc oxide | zirconium oxide | rutile titanium oxide | rutile titanium oxide | | | | TiO₂ fine particle water dispersion | | |
| Polysiloxane | X40-9225 | | | XR31- B2733 | X40-9225 | | - | X-22-164B | X40- 9225 | Condensate of tetrafunctional silane | |
| Additives | methanesulfonic acid | acetic acid | methanesulfonic acid | | PLADD ED151 acetylacetone | - | methanesulfonic aicd | methanesulfonic acid | - | - | - |
| Organic solvent | methyl ethyl ketone | | | | | | | | | | isopropyl alcohol |
| Dispersibility | A | A | A | A | A | D | D | D | D | D | A |
| Coating film transparency | A | A | A | A | C | - | - | - | - | - | occurrence of crack in film production |
| Yellowness | A | A | A | A | C | - | - | - | - | - | |
| Ultraviolet light resistance | A | A | A | A | C | - | - | - | - | - | |

### Example D1

In a container, 100 parts by weight of powdery rutile titanium oxide fine particles (average primary particle diameter: 30 nm), 100 parts by weight of an alkoxy-terminated methyl-based silicone oligomer having Mw of 2,000 (available from Shin-Etsu Chemical Co., Ltd., trade name: X40-9225) as polyfunctional polysiloxane, 1 part by weight of an isopropyl alcohol 75% dilute solution of di-isopropoxy·ethyl acetoacetate aluminum and 700 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (D-1) having a solids concentration of 20% by weight was obtained. The results of evaluation of properties of this composition are set forth in Table D1.

### Example D2

A metal oxide fine particle-containing polysiloxane composition (D-2) having a solids concentration of 20% by weight was prepared in the same manner as in Example D1, except that 100 parts by weight of powdery zinc oxide fine particles (average primary particle diameter: 20 nm) were used instead of the rutile titanium oxide fine particles. The results of evaluation of properties of this composition are set forth in Table D1.

### Example D3

A metal oxide fine particle-containing polysiloxane composition (D-3) having a solids concentration of 20% by weight was prepared in the same manner as in Example D1, except that 100 parts by weight of powdery zirconium oxide fine particles (average primary particle diameter: 20 nm) were used instead of the rutile titanium oxide fine particles, and 1 part by weight of an isopropyl alcohol 75% dilute solution of tri-n-butoxy·ethyl acetoacetate zirconium was used instead of the isopropyl alcohol 75% dilute solution of di-isopropoxy·ethyl acetoacetate aluminum. The results of evaluation of properties of this composition are set forth in Table D1.

### Example D4

A metal oxide fine particle-containing polysiloxane composition (D-4) having a solids concentration of 20% by weight was prepared in the same manner as in Example D1, except that 100 parts by weight of an alkoxy-terminated methyl-based silicone polymer having Mw of 10,000 (available from GE Toshiba Silicone Co., Ltd., trade name: XR31-B2733) were used instead of the silicone oligomer (X40-9225) as polyfunctional polysiloxane, and 1 part by weight of an isopropyl alcohol 75% dilute solution of tri-n-butoxy·ethyl acetoacetate zirconium was used instead of the isopropyl alcohol 75% dilute solution of di-isopropoxy·ethyl acetoacetate aluminum. The results of evaluation of properties of this composition are set forth in Table D1.

### Comparative Example D1

In a container, 100 parts by weight of powdery rutile titanium oxide fine particles (average primary particle diameter: 30 nm), 100 parts by weight of an alkoxy-terminated methyl-based silicone oligomer having Mw of 2,000 (available from Shin-Etsu Chemical Co., Ltd., trade name: X40-9225) as polyfunctional polysiloxane, 9 parts by weight of a polyoxyethylene alkylphosphoric ester (available from Kusumoto Chemicals, Ltd., trade name: PLADD ED151), 5 parts by weight of acetylacetone and 700 parts by weight of methyl ethyl ketone were placed. To this mixture, 2000 parts by weight of zirconia beads of 0.1 mm diameter were added, and they were stirred by the use of a bead mill at 1500 rpm for 1 hour to disperse the fine particles. Thus, a metal oxide fine particle-containing polysiloxane composition (D-a) having a solids concentration of 20% by weight was obtained. The results of evaluation of properties of this composition are set forth in Table D2.

### Comparative Example D2

Powdery rutile titanium oxide fine particles were dispersed in methyl ethyl ketone in the same manner as in Example D1, except that the isopropyl alcohol 75% dilute solution of diisopropoxy·ethyl acetoacetate aluminum was not used. However, the titanium oxide fine particles were sedimented.

### Comparative Example D3

Powdery rutile titanium oxide fine particles were dispersed in methyl ethyl ketone in the same manner as in Example D1, except that polyfunctional polysiloxane was not used. However, the titanium oxide fine particles were sedimented.

### Comparative Example D4

Powdery rutile titanium oxide fine particles were dispersed in methyl ethyl ketone in the same manner as in Example D1, except that polydimethylsiloxane containing no Si-OR bond (R is an alkyl group) and no Si-OH bond and having methacrylic structures at both ends (available from Shin-Etsu Chemical Co., Ltd., trade name: X-22-164B) was used instead of the polyfunctional polysiloxane. However, the titanium oxide fine particles were sedimented.

### Comparative Example D5

In a container, 300 parts by weight of a titanium oxide fine particle water dispersion wherein anatase titanium oxide fine particles had been beforehand dispersed in water ("STS-01" available from Ishihara Sangyo Kaisha, Ltd., TiO₂ concentration: 30% by weight, volume-average dispersed particle diameter of titanium oxide fine particles: 60 nm, organic dispersing agent: 0% by weight) were placed, and thereto were added 100 parts by weight of an alkoxy-terminated methyl-based silicone oligomer (available from Shin-Etsu Chemical Co., Ltd., trade name: X40-9225) and 500 parts by weight of methyl ethyl ketone. To this mixture, 2000 parts by weight of zirconia beads of 0.1 mm diameter were further added, and they were stirred by the use of a bead mill at 1500 rpm for 1 hour to disperse the fine particles. However, the titanium oxide fine particles were sedimented.

### Comparative Example D6

In a container, 300 parts by weight of a titanium oxide fine particle water dispersion ("STS-01" available from Ishihara Sangyo Kaisha, Ltd.) were placed, and thereto were added 200 parts by weight of a condensate of only a tetrafunctional silane compound (available from Colcoat Co., Ltd., trade name: Ethyl Silicate 48) and 500 parts by weight of methyl ethyl ketone. To this mixture, 2000 parts by weight of zirconia beads of 0.1 mm diameter were further added, and they were stirred by the use of a bead mill at 1500 rpm for 1 hour to disperse the fine particles. However, the titanium oxide fine particles were sedimented.

### Comparative Example D7

A metal oxide fine particle-containing polysiloxane composition (D-e) was prepared by dispersing titanium oxide fine particles in the same manner as in Comparative Example D6, except that methyl ethyl ketone was replaced with 500 parts by weight of isopropyl alcohol. In this composition, the titanium oxide fine particles were favorably dispersed, but a crack occurred in the production of a film.

**Table D1**

| | Ex. D1 | Ex. D2 | Ex. D3 | EX. D4 |
|---|---|---|---|---|
| Oxide fine particles | rutile titanium oxide | zinc oxide | zirconium oxide | rutile titanium oxide |
| Polysiloxane | X40-9225 | | | XR31-B2733 |
| Additives | di-isopropoxy·ethyl aluminum acetoacetate | | tri-n-butoxy·ethyl acetoacetate zirconium | |
| Organic solvent | methyl ethyl ketone | | | |
| Dispersibility | A | A | A | A |
| Coating film transparency | A | A | A | A |
| Yellowness | A | A | A | A |
| Ultraviolet light resistance | A | A | A | A |

**Table D2**

| | Comp. Ex. D1 | Comp. Ex. D2 | Comp. Ex. D3 | Comp. Ex. D4 | Comp. Ex. D5 | Comp. Ex. D6 | Comp. Ex. D7 |
|---|---|---|---|---|---|---|---|
| Oxide fine particles | rutile titanium oxide | | | | TiO₂ fine particle water dispersion | | |
| Polysiloxane | X40-9225 | | - | | X40-9225 | Condensate of tetrafunctional silane | |
| Additives | PLADD ED151 acetylacetone | - | di-isopropoxyethyl acetoacetate aluminum | di-isopropoxy·ethyl acetoacetate aluminum | - | - | - |
| Organic solvent | methyl ethyl ketone | | | | | | isopropyl alcohol |
| Dispersibility | A | D | D | D | D | D | A |
| Coating film transparency | C | - | - | - | - | - | occurrence of crack in film production |
| Yellowness | C | - | - | - | - | - | |
| Ultraviolet light resistance | C | - | - | - | - | - | |

## Claims

1. An oxide fine particle-containing polysiloxane composition obtained by mixing:
(A) silicon oxide fine particles and/or metal oxide fine particles with
(B1) polyfunctional polysiloxane which is obtained by allowing alkoxy-terminated polyfunctional polysiloxane (b1) represented by the following average compositional formula (1) :
R¹ₐSiO_{b}(OR²)_{c} (1)
wherein R¹ is a hydrogen atom or a monovalent hydrocarbon group having no oxyalkylene group, when plural R¹ are present, they may be the same as or different from one another, R² is an alkyl group, when plural R² are present, they may be the same as or different from one another, a is more than 0 but less than 2, b is more than 0 but less than 2, c is more than 0 but less than 4, and a+b×2+c=4, and
having a weight-average molecular weight, as measured by gel permeation chromatography, of not less than 500 but less than 3,000 in terms of polystyrene, and hydroxy-terminated polydimethylsiloxane (b2) having a weight-average molecular weight, as measured by gel permeation chromatography, of not less than 2,000 but not more than 100,000 in terms of polystyrene to undergo dealcoholization reaction in a weight ratio (b1/b2) of 3/97 to 55/45 based on 100 parts by weight of the total thereof, or
(B2) polyfunctional polysiloxane which is obtained by allowing hydroxy-terminated polyfunctional polysiloxane (b3) represented by the following average compositional formula (2) :
R¹ₐSiO_{b}(OH)_{c} (2)
wherein R¹ is a hydrogen atom or a monovalent hydrocarbon group having no oxyalkylene group, when plural R¹ are present, they may be the same as or different from one another, a is more than 0 but less than 2, b is more than 0 but less than 2, c is more than 0 but less than 4, and a+b×2+c=4, and having a weight-average molecular weight, as measured by gel permeation chromatography, of not less than 500 but less than 3,000 in terms of polystyrene, and alkoxy-terminated polydimethylsiloxane (b4) having a weight-average molecular weight, as measured by gel permeation chromatography, of not less than 2,000 but not more than 100,000 in terms of polystyrene to undergo dealcoholization reaction in a weight ratio (b3/b4) of 3/97 to 55/45 based on 100 parts by weight of the total thereof, or
(B3) polyfunctional polysiloxane which is represented by the following average compositional formula (3):
R¹ₐSiO_{b}(OR³)_{c} (3)
wherein R¹ is a hydrogen atom or a monovalent hydrocarbon group having no oxyalkylene group, when plural R¹ are present, they may be the same as or different from one another, R³ is a hydrogen atom or an alkyl group, when plural R³ are present, they may be the same as or different from one another, a is more than 0 but less than 2, b is more than 0 but less than 2, c is more than 0 but less than 4, and a+b×2+c=4, in an organic solvent in the presence of a basic compound, an acidic compound or a metal chelate compound and thereby dispersing the oxide fine particles (A) in the organic solvent.

2. The oxide fine particle-containing polysiloxane composition as claimed in claim 1, wherein the oxide fine particles (A) and the polyfunctional polysiloxane (B1), (B2) or (B3) are mixed in the presence of the basic compound.

3. The oxide fine particle-containing polysiloxane composition as claimed in claim 2, wherein the basic compound is an organic amine compound.

4. The oxide fine particle-containing polysiloxane composition as claimed in any one of claims 1 to 3, wherein the oxide fine particles (A) and the polyfunctional polysiloxane (B1), (B2) or (B3) are mixed by a bead mill.

5. The oxide fine particle-containing polysiloxane composition as claimed in any one of claims 1 to 4, wherein the polyfunctional polysiloxane (B1), (B2) or (B3) is mixed in an amount of 1 to 1000 parts by weight in terms of a perfect hydrolysis condensate, based on 100 parts by weight of the oxide fine particles (A).

6. The oxide fine particle-containing polysiloxane composition as claimed in any one of claims 1 to 5, which has a water content of not more than 5% by weight.

7. The oxide fine particle-containing polysiloxane composition as claimed in any one of claims 1 to 6, which is an oxide fine particle-containing polysiloxane composition obtained by mixing the oxide fine particles (A) with the polyfunctional polysiloxane (B1) or (B2), wherein the polyfunctional polysiloxane (B1) or (B2) is further subjected to hydrolysis/condensation and then mixed with the oxide fine particles (A).

8. The oxide fine particle-containing polysiloxane composition as claimed in any one of claims 1 to 7, which is an oxide fine particle-containing polysiloxane composition obtained by mixing the oxide fine particles (A) with the polyfunctional polysiloxane (B1) or (B2), wherein a catalyst in the dealcoholization reaction is a metal chelate compound.

9. The oxide fine particle-containing polysiloxane composition as claimed in any one of claims 1 to 6, which is an oxide fine particle-containing polysiloxane composition obtained by mixing the oxide fine particles (A) with the polyfunctional polysiloxane (B3), wherein the weight-average molecular weight of the polyfunctional polysiloxane (B3), as measured by gel permeation chromatography, is in the range of 1,000 to 100,000 in terms of polystyrene.

10. A cured product obtained from the oxide fine particle-containing polysiloxane composition of any one of claims 1 to 9.

11. An LED sealing material obtained by further mixing the oxide fine particle-containing polysiloxane composition of any one of claims 1 to 9 with a fluorescent substance.

12. A process for preparing an oxide fine particle-containing polysiloxane composition, comprising preparing:
(B1) polyfunctional polysiloxane which is obtained by allowing alkoxy-terminated polyfunctional polysiloxane (b1) represented by the following average compositional formula (1) :
R¹ₐSiO_{b}(OR²)_{c} (1)
wherein R¹ is a hydrogen atom or a monovalent hydrocarbon group having no oxyalkylene group, when plural R¹ are present, they may be the same as or different from one another, R² is an alkyl group, when plural R² are present, they may be the same as or different from one another, a is more than 0 but less than 2, b is more than 0 but less than 2, c is more than 0 but less than 4, and a+b×2+c=4, and having a weight-average molecular weight, as measured by gel permeation chromatography, of not less than 500 but less than 3,000 in terms of polystyrene, and hydroxy-terminated polydimethylsiloxane (b2) having a weight-average molecular weight, as measured by gel permeation chromatography, of not less than 2,000 but not more than 100,000 in terms of polystyrene to undergo dealcoholization reaction in a weight ratio (b1/b2) of 3/97 to 55/45 based on 100 parts by weight of the total thereof, or
(B2) polyfunctional polysiloxane which is obtained by allowing hydroxy-terminated polyfunctional polysiloxane (b3) represented by the following average compositional formula (2) :
R¹ₐSiO_{b}(OH)_{c} (2)
wherein R¹ is a hydrogen atom or a monovalent hydrocarbon group having no oxyalkylene group, when plural R¹ are present, they may be the same as or different from one another, a is more than 0 but less than 2, b is more than 0 but less than 2, c is more than 0 but less than 4, and a+b×2+c=4, and having a weight-average molecular weight, as measured by gel permeation chromatography, of not less than 500 but less than 3,000 in terms of polystyrene, and alkoxy-terminated polydimethylsiloxane (b4) having a weight-average molecular weight, as measured by gel permeation chromatography, of not less than 2,000 but not more than 100,000 in terms of polystyrene to undergo dealcoholization reaction in a weight ratio (b3/b4) of 3/97 to 55/45 based on 100 parts by weight of the total thereof, or
(B3) polyfunctional polysiloxane which is represented by the following average compositional formula (3):
R¹ₐSiO_{b}(OR³)_{c} (3)
wherein R¹ is a hydrogen atom or a monovalent hydrocarbon group having no oxyalkylene group, when plural R¹ are present, they may be the same as or different from one another, R³ is a hydrogen atom or an alkyl group, when plural R³ are present, they may be the same as or different from one another, a is more than 0 but less than 2, b is more than 0 but less than 2, c is more than 0 but less than 4, and a+b×2+c=4, and then mixing the polyfunctional polysiloxane (B1), (B2) or (B3) with silicon oxide fine particles and/or metal oxide fine particles (A) in an organic solvent in the presence of a basic compound, an acidic compound or a metal chelate compound.

13. The process for preparing an oxide fine particle-containing polysiloxane composition as claimed in claim 12,
wherein the oxide fine particles (A) and the polyfunctional polysiloxane (B1), (B2) or (B3) are mixed in the presence of the basic compound.

14. The process for preparing an oxide fine particle-containing polysiloxane composition as claimed in claim 13,
wherein the basic compound is an organic amine compound.

15. The process for preparing an oxide fine particle-containing polysiloxane composition as claimed in any one of claim 12 to 14, wherein the oxide fine particles (A) and the polyfunctional polysiloxane (B1), (B2) or (B3) are mixed by a bead mill.

16. The process for preparing an oxide fine particle-containing polysiloxane composition as claimed in any one of claim 12 to 15, which is a process for preparing an oxide fine particle-containing polysiloxane composition comprising mixing the oxide fine particles (A) with the polyfunctional polysiloxane (B1) or (B2), wherein the polyfunctional polysiloxane (B1) or (B2) is further subjected to hydrolysis/condensation and then mixed with the oxide fine particles (A).

17. The process for preparing an oxide fine particle-containing polysiloxane composition as claimed in any one of claim 12 to 16, which is a process for preparing an oxide fine particle-containing polysiloxane composition comprising mixing the oxide fine particles (A) with the polyfunctional polysiloxane (B1) or (B2), wherein a catalyst in the dealcoholization reaction is a metal chelate compound.
